# EUROPÄISCHE PATENTANMELDUNG

(11) **EP 2 933 854 A1**
(43) Veröffentlichungstag der Anmeldung: **21.10.2015**
(21) Anmeldenummer: 14197512.8
(22) Anmeldetag: 11.12.2014
(51) Int. Cl.: H01L 51/54

(54) **Hostmaterialien**

(30) Priorität: 15.04.2014 EP 14164796
(71) Anmelder: cynora GmbH, 76646 Bruchsal (DE)
(72) Erfinder: Volz, Daniel, 76137 Karlsruhe (DE); Ambrosek, David, 10437 Berlin (DE)
(74) Vertreter: Hoppe, Georg Johannes

(57) **Zusammenfassung**

Die Erfindung betrifft die Verwendung eines ambipolaren Ladungstransportmoleküls aufweisend eine Struktur der Formel 1 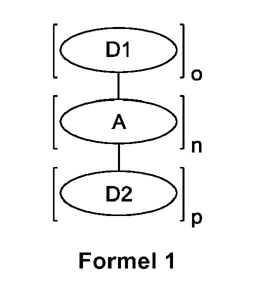 in elektronischen Vorrichtungen wobei A eine Akzeptorgruppe und D1 und D2 Donorgruppen darstellen.

## Beschreibung

Die Erfindung betrifft unsymmetrische Moleküle der allgemeinen Formel 1, die aufgrund ihrer räumlichen Gestalt löslich und für die Verwendung als Hostmaterialien in OLEDs (organic light emitting diodes) und anderen opto-elektronischen Bauelementen geeignet sind.

### Einleitung

Die auf OLED (Organic Light Emitting Diodes) basierende Technologie hat sich in den letzten Jahren im Bereich von Beleuchtungs- und Displayapplikationen als kostengünstige und energieeffiziente Technik durchgesetzt. Entsprechende Produkte sind bereits heute kommerziell erhältlich und werden in verschiedensten Arten von opto-elektronischen Bauelementen eingesetzt.

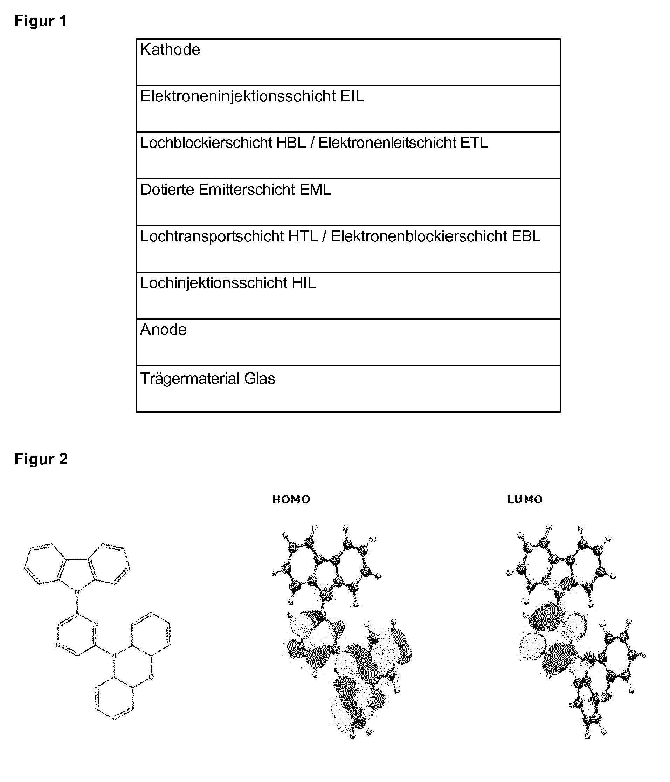

In der Regel sind derartige Bauteile in Schichtstrukturen realisiert, welche überwiegend aus organischen Materialien bestehen. Zum besseren Verständnis ist in Figur 1 ein vereinfachter Aufbau exemplarisch dargestellt. Herzstück solcher Bauteile ist die Emitterschicht, welche typischerweise zwischen einer Anode und einer Kathode angeordnet ist und die in der Regel aus einem Hostmaterial besteht, in welches die emittierenden Moleküle eingebettet sind. Weitere Schichten, wie die Lochinjektionsschicht, die Lochtransportschicht, die Elektronenleitschicht und die Zwischenschicht bewirken im Allgemeinen eine dramatisch verbesserte Effizienz der Bauteile. Bei Anlegen eines Stroms/einer Spannung treffen sich negative Ladungsträger (Elektronen) und positive Ladungsträger (Löcher), die zu sogenannten Exzitonen (= angeregte Zustände) rekombinieren. Die in den Exzitonen enthaltene Energie kann von den entsprechenden Emittern in Form von Licht abgegeben werden, wobei man in diesem Fall von Elektrolumineszenz spricht. Einen Überblick über die Funktion von OLEDs findet sich beispielsweise bei H. Yersin, Top. Curr. Chem. 2004, 241, 1 und H. Yersin, "Highly Efficient OLEDs with Phosphorescent Materials"; Wiley-VCH, Weinheim, Germany, 2008.

Alle Materialien eines opto-elektronischen Bauelements müssen so gewählt werden, dass eine optimale Injektion der Ladungen (Löcher und Elektronen) von den Elektroden und Ausbildung der Exzitonen in der Emitterschicht ermöglicht wird. Die Entwicklung effektiver Hostmaterialien ist für die Produktion effizienter opto-elektronischer Bauelemente hierbei genau so wichtig wie die Entwicklung neuer Emittermaterialien.

Hostmaterialien müssen eine effiziente Energieniveau-Nivellierung ermöglichen, um die Energieniveaus der verwendeten Elektroden stufenweisen an die Energieniveaus der Emittermoleküle anzupassen. Weiterhin sollten die verwendeten Hostmaterialien idealerweise einen ausgeglichenen Ladungstransport (eine Ladungsträgerbalance von positiven und negativen Ladungsträgern) gewährleisten. Gängige Hostmaterialien, wie CBP, mCP, TPBi und TCTA sind jedoch nur in der Lage entweder bevorzugt Löcher oder bevorzugt Elektronen zu transportieren. Beim Einsatz solcher unipolaren Materialien findet die Ladungsträgerrekombination und Bildung der Exzitonen meist nahe der Grenzfläche zur Ladungstransport-Schicht statt. Diese räumliche Beschränkung kann bei wachsender Helligkeit oder Stromdichte zu einer Effizienz-Abnahme der optoelektronischen Bauteile ("roll-off") führen. Durch die schmale Rekombinationszone trägt außerdem nur ein geringer Teil der Moleküle zum Ladungstransport, zur Exzitonbildung und schließlich zur Lichtemission bei, wodurch das Bauteil keine optimale Betriebsdauer erreichen kann. Dies kann durch den Einsatz von ambipolaren Hosts für OLEDs in der Emissionsschicht umgangen werden. Dabei werden zum einen Donor- und Akzeptormoleküle als Mischungen eingesetzt (K. Goushi, K. Yoshida, K. Sato, C. Adachi, Nat. Photonics 2012, 6, 253-258), welche die Effizienz der Bauteile vor allem bei hohen Stromdichten nachhaltig verbessern. Allerdings führen die benötigten hohen Konzentrationen des zusätzlichen Ladungstransportmaterials häufig zu Phasentrennungen und dadurch zu Verschlechterungen der Langzeitstabilitäten der optoelektronischen Bauteile. Geeigneter sind hier sogenannte ambipolare Materialien, bei denen beide Funktionalitäten von ein und demselben Molekül erfüllt werden.

Als lochtransportierende Einheiten (Donoren) der ambipolaren Moleküle werden vor allem Diarylamine oder Carbazol-Strukturen verwendet. Die hiermit hergestellten optoelektronischen Bauteile zeigen jedoch häufig Stabilitätsprobleme bzw. es ist eine geringe Langzeitstabilität festzustellen. Dies kann auf bekannte Degradationsmechanismen zurückgeführt werden, die auf der Abspaltung von Resten bei Diarylamin-Gruppen oder der Oligomerisierung/Knüpfung neuer Bindungen bei Verwendung von Carbazol-Gruppen beruhen. Die Eigenschaften der Bauteile werden durch diese Prozesse derart verändert, dass sich ihre Energieniveaus verschieben und es mittelfristig zu einer Zerstörung des Bauteils kommt. Durch Absättigung der reaktiven Positionen der lochtransportierenden Einheiten, z. B. durch tert-Butylgruppen, wurde versucht, dieses Problem zu umgehen (F. So, D. Kondakov, Ad. Mater. 2010, 22, 3762-3777). Allerdings hat dieses Vorgehen wiederrum den Nachteil, dass sich zum einen Parameter wie die Ladungsträgermobilität negativ verändern, was zu Morphologie-Problemen, insbesondere Phasenseparation also z. B. dem Auskristallisieren der Hostmaterialien und/oder der darin enthaltenen Emittermoleküle führen kann. Zum anderen können auch diese Schutzgruppen im Langzeitbetrieb der Bauteile abgespalten werden, was zu den eben beschriebenen Problemen führt.

Häufig werden zur Gewährleistung der Funktionalität der Materialien große, planare, aromatische Substituenten in den Molekülen eingesetzt. Diese Reste sorgen, wie dem Fachmann bekannt ist, oft durch sogenanntes pi-pi-Stacking und daraus resultierende effiziente Packung zu einer starken Herabsetzung der Löslichkeit. Strategien zur Erhöhung der Löslichkeit nurtzen häufig die Einführung von Löslichkeitsvermittelnden Gruppen wie lange, optional verzeigte Alkylketten sowie sterisch anspruchsvolle Reste wie tert-Butyl. Die Funktionsweise dieser Gruppen besteht in der Herabsetzung der Löslichkeit durch Störung der Packung, wodurch die Gitterenergie des Festkörpers herabgesetzt wird und die Solvatation, also das Auflösen, erleichtert wird. Unglücklicherweise sorgen derartige Strategien häufig zu einer Beeinflussung der Morphologie. Wie dem Fachmann bekannt ist, lässt sich der Ladungstransport in organischen Halbleitern durch die Marcus-Gleichung beschreiben. Demnach ist die kinetische Rate k für den Elementarschritt der Ladungsübertragung zwischen zwei Species propartional zum Quadrat des Überlappungsintegrals zwischen Anfangs- und Endzustand. Dieses Integral hängt allgemein vom Abstand der beiden Moleküle ab, zwischen denen Ladung übertragen wird. Durch Löslichkeitsvermittelnde, sterisch Anspruchsvolle Gruppen sinkt der mittlere Abstand ab, wodurch die Rate k sinkt und entsprechend die makroskopische Leitfähigkeit des betrachteten Materials sinkt. Bei niedriger Leitfähigkeit sind höhere Spannungen nötig, um in einer OLED eine ausreichende Lichtstärke zu erzeugen, außerdem wird durch den damit verbundenen höheren elektrischen Stress die Lebensdauer negativ beeinflusst. Da Hostmaterialien naturgemäß in höheren Konzentrationen als Emittermoleküle in Emissionsschichten zum Einsatz kommen, beeinflussen Löslichkeitsvermittelnde Gruppen in Hostmaterialien die morphologischen Eigenschaften der Emissionsschicht besonders stark.

Wird auf löslichkeitsvermittelnde Gruppen gänzlich verzichtet, so kann unter Umständen auch die Verarbeitung aus der Gasphase nicht möglich sein: Die durch löslichkeitsvermittelnde Gruppen beeinflusste Gitterenergie muss auch zur Verdampfung einer Verbindung überwunden werden. Wird bei einem schwerflüchtigen Molekül durch Einführung eines nicht zu schweren Substituenten die Gitterenergie hinreichend herab gesetzt, so kann die Verdampfungstemperatur trotz der insgesamt etwas höheren Molekülmasse im Vergleich zur schwerlöslichen Referenzverbindung herabgesetzt werden.

Die Aufgabe der vorliegenden Erfindung besteht somit in der Bereitstellung neuer ambipolarer Hostmaterialien mit verbesserten Eigenschaften.

### Beschreibung

Es wurde überraschend gefunden, dass optoelektronische Bauelemente, die nichtspiegelsymmetrische organische Moleküle gemäß nachstehender Formel 1 enthalten, deutliche Verbesserungen gegenüber dem Stand der Technik aufweisen, insbesondere beim Einsatz als Matrixmaterialien für lumineszierende Emitter, aber auch bei Verwendung als Elektronentransportmaterial oder als Lochinjektionsmaterial oder als Lochblockiermaterial.

Die erfindungsgemäßen organischen Moleküle umfassen mindestens eine Akzeptoreinheit, also eine Einheit mit elektronenziehenden Eigenschaften, an die bis zu fünf, bevorzugt bis zu vier, besonders bevorzugt bis zu zwei Donoreinheiten, also Einheiten mit elektronenschiebenden Eigenschaften, kovalent gebunden sind. Bei den Donoreinheiten handelt es sich um sechs- oder fünfgliedrige Ringsysteme, wobei mindestens eine Donoreinheit sechsgliedrig sein muss und mindestens zwei unterschiedliche Donoreinheiten verwendet werden müssen. Je nach Akzeptoreinheit können an diese bis zu vier weitere Akzeptoreinheiten kovalent gebunden sein.

Die Erfindung stellt organische Moleküle der allgemeinen Formel 1 bereit, 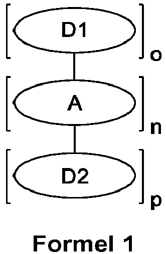 mit
A = eine Akzeptorgruppe mit elektronenziehenden Eigenschaften unabhängig voneinander ausgewählt aus der Gruppe aus Pyridin, Triazin, Pyrimidin, Pyrazin, Triazin, Oxazol, Thiazol, Imidazol, Pyrazol, Isoxazol, Isothiazol, 1,2,3-Triazol, 1,2,4-Triazol, 1,2,4-Oxadiazol, 1,2,4-Thiadiazol, Tetrazol, 1,2,3,4-Oxatriazol, 1,2,3,4-Thiatriazol, die mit einem oder mehreren Resten R¹ substituiert sein können, wobei zwei oder mehr Reste R¹ miteinander verknüpft sein können und einen Ring bilden können, P(=O)R¹₂, P(=O)R¹, P(=S)R¹₂, P(=S)R¹, P(=Se)R¹₂, P(=Se)R¹, SO₂, Benzimidazol, Benzoxazol, Benzothiazol;
wobei gilt
R¹ ist bei jedem Auftreten gleich oder verschieden Wasserstoff, Halogen, Deuterium, Gruppen, die über Stickstoff (-NR₂²) oder Sauerstoff- (-OR²) gebunden sind, Alkyl- (linear, verzweigt oder zyklisch), Heteroalkyl-, Aryl-, Heteroaryl-, Alkenyl-, Alkinyl-Gruppen oder substituierte Alkyl- (linear, verzweigt oder zyklisch), Heteroalkyl-, Aryl-, Heteroaryl- und Alkenyl-Gruppen mit Substituenten wie Halogene oder Deuterium, Alkylgruppen (linear verzweigt oder zyklisch);
R² ist bei jedem Auftreten gleich oder verschieden Wasserstoff, Deuterium, Alkyl- (linear, verzweigt oder zyklisch), Heteroalkyl-, Aryl-, Heteroaryl-, Alkenyl-, Alkinyl-Gruppen oder substituierte Alkyl- (linear, verzweigt oder zyklisch), Heteroalkyl-, Aryl-, Heteroaryl- und Alkenyl-Gruppen mit Substituenten wie Halogene oder Deuterium, Alkylgruppen (linear, verzweigt oder zyklisch);
und
D1 = eine Donorgruppe mit elektronenschiebenden Eigenschaften, aufweisend eine Struktur der Formel 1a;

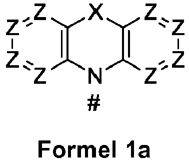

D2 = eine Donorgruppe mit elektronenschiebenden Eigenschaften, aufweisend eine Struktur der Formel 1b; 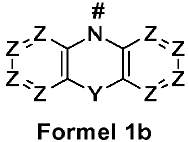 wobei mindestens zwei verschiedene Donorgruppen D1 und D2 verwendete werden und für die verwendeten Symbole und Indizes gilt:
- n: ist eine ganze Zahl zwischen 1 und 5;
- o: ist eine ganze Zahl zwischen 1 und 4;
- p: eine ganze Zahl zwischen 1 und 4;
wobei o + p ≤ 5;
- X: ist gleich oder verschieden eine bivalente Brücke ausgewählt aus O, S, S=O, SO₂, Se, Se=O, SeO₂, C(R³)₂, C=NR³, C=C(R³)₂, Si(R³)₂, N(R³), P(R³), P(=O)R³ oder B(R³);
- Y: ist bei jedem Auftreten gleich oder verschieden eine kovalente Einfachbindung oder eine bivalente Brücke ausgewählt aus O, S, S=O, SO₂, Se, Se=O, SeO₂, C(R³)₂, C=NR³, C=C(R³)₂, Si(R³)₂, N(R³), P(R³), P(=O)R³ oder B(R³);
- Z: ist bei jedem Auftreten gleich oder verschieden CR² oder N;
- R³: ist bei jedem Auftreten gleich oder verschieden H, D, OR⁵, SR⁵ oder C(R⁵)₃;
- R⁵: ist bei jedem Auftreten gleich oder verschieden Wasserstoff, eine Alkylgruppe oder eine Arylgruppe;
und wobei die Verknüpfung mit A jeweils an der mit # gekennzeichneten Stelle in Form einer Einfachbindung stattfindet.

In einer alternativen Ausführungsform der Erfindung ist X eine bivalente organische Brücke ausgewählt aus der Gruppe bestehend aus substituierten und unsubstituierten Alkylen-(linear, verzweigt oder zyklisch), Alkenylen-, Alkinylen-, Arylen- und Heteroarylen-Gruppen, O, NR³, C=CR³₂, C=NR³, SiR³₂ S, S(O), S(O)₂, BR³, PR³, P(O)R³, wobei auch Kombinationen dieser Einheiten möglich sind (z.B. durch O unterbrochene Alkylen- (linear, verzweigt oder zyklisch), Alkenylen-, Alkinylen-, Arylen- und Heteroarylen-Gruppen).

In einer weiteren alternativen Ausführungsform ist Y eine kovalente Einfachbindung oder eine bivalente organische Brücke ausgewählt aus der Gruppe bestehend aus substituierten und unsubstituierten Alkylen- (linear, verzweigt oder zyklisch), Alkenylen-, Alkinylen-, Arylen-und Heteroarylen-Gruppen, O, NR³, C=CR³₂, C=NR³, SiR³₂ S, S(O), S(O)₂, BR³, PR³, P(O)R³, wobei auch Kombinationen dieser Einheiten möglich sind (z.B. durch O unterbrochene Alkylen- (linear, verzweigt oder zyklisch), Alkenylen-, Alkinylen-, Arylen- und Heteroarylen-Gruppen).

Erfindungsgemäß ist auch die alternative Ausführungsform, in der R¹ bei jedem Auftreten gleich oder verschieden H, D, F, Cl, Br, I, B(OR³)₂, CHO, C(=O)R³, CR³=C(R³)₂, CN, C(=O)OR³, C(=O)N(R³)₂, Si(R³)₃, NO₂, P(=O)(R³)₂, OSO₂R³, OR³, S(=O)R³, S(=O)₂R³, eine geradkettige Alkyl-, Alkoxy- oder Thioalkylgruppe mit 1 bis 20 C-Atomen oder eine verzweigte oder cyclische Alkyl-, Alkoxy- oder Thioalkylgruppe mit 3 bis 20 C-Atomen oder eine Alkenyl- oder Alkinylgruppe mit 2 bis 20 C-Atomen ist, wobei die oben genannten Gruppen jeweils mit einem oder mehreren Resten R³ substituiert sein können und wobei eine oder mehrere CH₂- Gruppen in den oben genannten Gruppen durch -R³C=CR³-, -C=C-, Si(R³)₂, C=O, C=S, C=NR³, -C(=O)O-, -C(=O)NR³-, NR³, P(=O)(R³), -O-, -S-, SO oder SO₂ ersetzt sein können und wobei ein oder mehrere H-Atome in den oben genannten Gruppen durch D, F, Cl, Br, I, CN oder NO₂ ersetzt sein können, oder ein aromatisches Ringsystem mit 6 bis 30 aromatischen Ringatomen, das jeweils durch einen oder mehrere Reste R³ substituiert sein kann, oder eine Aryloxygruppe mit 6 bis 30 aromatischen Ringatomen, die durch einen oder mehrere Reste R³ substituiert sein kann, wobei zwei oder mehr Reste R¹ miteinander verknüpft sein können und einen Ring bilden können.

In einer alternativen Ausführungsform ist R² bei jedem Auftreten gleich oder verschieden H, D, F, Cl, Br, I, B(OR³)₂, CHO, C(=O)R³, CR³=C(R³)₂, CN, C(=O)OR³, C(=O)N(R³)₂₎ Si(R³)₃, N(R³)₂, NO₂, P(=O)(R³)₂, OSO₂R³, OR³, S(=O)R³, S(=O)₂R³, eine geradkettige Alkyl-, Alkoxy-oder Thio-alkylgruppe mit 1 bis 20 C-Atomen oder eine verzweigte oder cyclische Alkyl-, Alkoxy- oder Thioalkylgruppe mit 3 bis 20 C- Atomen oder eine Alkenyl- oder Alkinylgruppe mit 2 bis 20 C- Atomen, wobei die oben genannten Gruppen jeweils mit einem oder mehreren Resten R³ substituiert sein können und wobei eine oder mehrere CH₂-Gruppen in den oben genannten Gruppen durch -R³C=CR³-, -C=C-, Si(R³)₂, C=O, C=S, C=NR³, - C(=O)O-, -C(=O)NR³-, NR³, P(=O)(R³), -O-, -S-, SO oder SO₂ ersetzt sein können und wobei ein oder mehrere H-Atome in den oben genannten Gruppen durch D, F, Cl, Br, I, CN oder NO₂ ersetzt sein können, oder ein aromatisches oder heteroaromatisches Ringsystem mit 5 bis 30 aromatischen Ringatomen, das jeweils durch einen oder mehrere Reste R³ substituiert sein kann, oder eine Aryloxy- oder Heteroaryloxygruppe mit 5 bis 60 aromatischen Ringatomen, die durch einen oder mehrere Reste R³ substituiert sein kann.

In einer alternativen Ausführungsform ist R³ bei jedem Auftreten gleich oder verschieden H, D, F, Cl, Br, I, B(OR⁴)₂, CHO, C(=O)R⁴, CR⁴=C(R⁴)₂, CN, C(=O)OR⁴, C(=O)N(R⁴)₂, Si(R⁴)₃, N(R⁴)₂, NO₂, P(=O)(R⁴)₂, OSO₂R⁴, OR⁴, S(=O)R⁴, S(=O)₂R⁴, eine geradkettige Alkyl-, Alkoxy-oder Thioalkylgruppe mit 1 bis 20 C-Atomen oder eine verzweigte oder cyclische Alkyl-, Alkoxy- oder Thioalkylgruppe mit 3 bis 20 C- Atomen oder eine Alkenyl- oder Alkinylgruppe mit 2 bis 20 C- Atomen, wobei die oben genannten Gruppen jeweils mit einem oder mehreren Resten R⁴ substituiert sein können und wobei eine oder mehrere CH₂-Gruppen in den oben genannten Gruppen durch -R⁴C=CR⁴-, -C=C-, Si(R⁴)₂, C=O, C=S, C=Se, C=NR⁴, - C(=O)O-, -C(=O)NR⁴-, NR⁴, P(=O)(R⁴), -O-, -S-, SO oder SO₂ ersetzt sein können und wobei ein oder mehrere H-Atome in den oben genannten Gruppen durch D, F, Cl, Br, I, CN oder NO₂ ersetzt sein können, oder ein aromatisches oder heteroaromatisches Ringsystem mit 5 bis 60 aromatischen Ringatomen, das jeweils durch einen oder mehrere Reste R⁴ substituiert sein kann, oder eine Aryloxy- oder Heteroaryloxygruppe mit 5 bis 60 aromatischen Ringatomen, die durch einen oder mehrere Reste R⁴ substituiert sein kann, wobei zwei oder mehr Reste R³ miteinander verknüpft sein können und einen Ring bilden können.
R⁴ ist bei jedem Auftreten gleich oder verschieden H, D, OR⁵, SR⁵ oder C(R⁵)₃.

In einer weiteren alternativen Ausführungsform ist R⁴ bei jedem Auftreten gleich oder verschieden H, D, F oder ein aliphatischer, aromatischer oder heteroaromatischer organischer Rest mit 1 bis 20 C-Atomen, in dem auch ein oder mehrere H-Atome durch D oder F ersetzt sein können; dabei können zwei oder mehr Substituenten R⁴ miteinander verknüpft sein und einen Ring bilden.

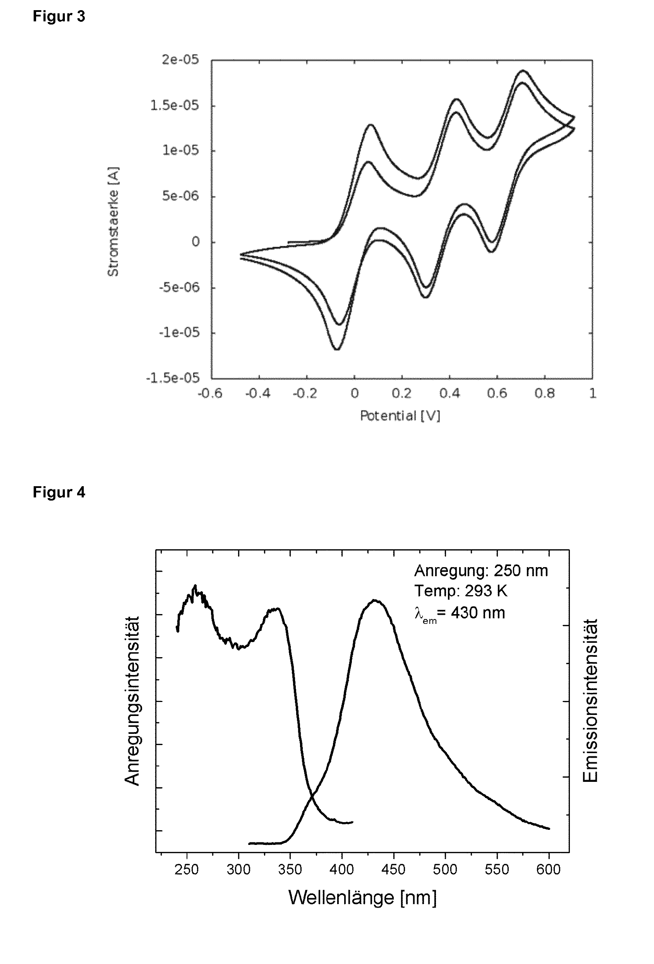

Die Strukturen der ambipolaren organischen Moleküle gemäß Formel 1 weisen, im Vergleich zu offenen Diarylsystemen bzw. Carbazol-artigen Systemen bei denen zentrale Fünfringe verwendet werden, eine erhöhte chemische und elektrochemische Stabilität auf. So werden die beiden in Diarylaminen verwendeten Arylreste miteinander verknüpft und ihre Abspaltung wird verhindert. Im Vergleich zu Materialien, die ausschließlich fünfgliedrige Ringsysteme enthalten, wird die Anzahl der reaktiven Positionen verringert bzw. bei ausschließlicher Verwendung von sechsgliedrigen Ringsystemen sogar komplett eliminiert. Die elektrochemische Stabilität verbessert sich vor allem durch die veränderten elektronischen Zustände. Das HOMO (highest occupied molecule orbital) von ambipolaren Molekülen ist auf der Donoreinheit lokalisiert, während das LUMO (lowest unoccupied molecule orbital) sich auf der Akzeptoreinheit befindet. So sitzt das HOMO bei literaturbekannten Verbindungen meist auf dem Fünfring. Dadurch wird der Zerfall solcher Moleküle begünstigt. Bei Vorhandensein eines Sechsrings liegt das HOMO aufgrund der niedrigeren Energie von beispielsweise Phenoxazin und Phenothiazin gegenüber Carbazol eher auf diesem (Figur 2). Die erhöhte Stabilität konnte für die erfindungsgemäßen organischen Moleküle durch Cyclovoltammetrie-Experimente bestätigt werden (Figur 3). Der Zerfall wird unterdrückt.

Durch das optionale Vorhandensein von fünfgliedrigen Einheiten in den erfindungsgemäßen organischen Molekülen können deren bekannte positive Eigenschaften, wie die gute Stapelung im amorphen Festkörper oder der gute Ladungstransport im Bauteil, weiterhin ausgenutzt werden.

Die erfindungsgemäßen organischen Moleküle gemäß Formel 1 weisen zudem eine hohe Triplett-Energie auf. Diese ist vor allem für die Kombination mit blauen Emittern vorteilhaft. Verursacht wird diese Eigenschaft durch die direkte Bindung von Donor- und Akzeptoreinheiten. Überraschend wurde dabei im Vergleich zu Molekülen des Stands der Technik eine signifikante Erhöhung der Triplet-Energie festgestellt. Bekannte Moleküle, bei denen die beiden Teile durch Brückeneinheiten miteinander verbunden sind, weisen deutlich geringere Triplett-Energien auf. Die Triplett-Energie ist insbesondere im Vergleich zu bereits bekannten Molekülen, bei denen Donor und Akzeptor über Spacereinheiten wie beispielsweise Phenylreste miteinander verknüpft sind, signifikant höher, sodass eine Verwendung der erfindungsgemäßen Moleküle in Kombination mit blauen und tiefblauen Emittern sowie solchen Emittern anderer Leuchtfarbe, die eine hohe Triplettenergie erfordern (etwa grün-emittierende TADF-Emitter). Ein Vergleich des erfindungsgemäßen Anknüpfungsmusters mit dem Anknüpfungsmuster des Standes der Technik ist in Beispiel 12 angegeben.
Durch die erforderliche Anwesenheit von unterschiedlichen Donoreinheiten D1 und D2 wird die Spiegelsymmetrie aufgehoben und entsprechend eine gegenüber den symmetrischen Grundsystemen (D1)ₒ-(A)ₙ-(D1)ₚ bzw. (D2)ₒ-(A)ₙ-(D2)ₚ erniedrigte Gitterenergie gefunden. Dies beeinflusst sowohl die Verarbeitung aus der Gasphase als auch aus Lösung vorteilhaft, wie eingangs dargelegt wurde.

In einer Ausführungsform weist in dem erfindungsgemäßen organischen Molekül der Formel 1 die Akzeptorgruppe A eine Struktur der Formel 2a auf und n ist gleich 1. 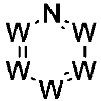 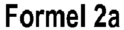 Mit
- W: ist bei jedem Auftreten gleich oder verschieden CR¹ oder N

Somit weist das erfindungsgemäße organische Molekül in dieser Ausführungsform eine Struktur der Formel 2 auf. 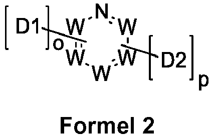 mit
D1 = eine Donorgruppe mit elektronenschiebenden Eigenschaften, aufweisend eine Struktur der Formel 1a; 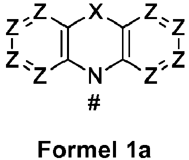 und
D2 = eine Donorgruppe mit elektronenschiebenden Eigenschaften, aufweisend eine Struktur der Formel 1b; 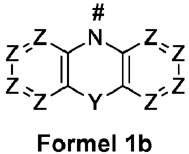 wobei mindestens zwei verschiedene Donorgruppen D1 und D2 verwendet werden und für die verwendeten Symbole und Indizes gilt:
- o: ist eine ganze Zahl zwischen 1 und 4;
- p: eine ganze Zahl zwischen 1 und 4;
wobei o + p ≤ 5;
- X: ist gleich oder verschieden eine bivalente Brücke ausgewählt aus O, S, S=O, SO₂, Se, Se=O, SeO₂, C(R³)₂, C=NR³, C=C(R³)₂, Si(R³)₂, N(R³), P(R³), P(=O)R³ oder B(R³);
- Y: ist bei jedem Auftreten gleich oder verschieden eine kovalente Einfachbindung oder eine bivalente Brücke ausgewählt aus O, S, S=O, SO₂, Se, Se=O, SeO₂, C(R³)₂, C=NR³, C=C(R³)₂, Si(R³)₂, N(R³), P(R³), P(=O)R³ oder B(R³);
- W: ist bei jedem Auftreten gleich oder verschieden CR¹ oder N;
- Z: ist bei jedem Auftreten gleich oder verschieden CR² oder N;
- R¹: ist bei jedem Auftreten gleich oder verschieden Wasserstoff, Halogen, Deuterium, Gruppen, die über Stickstoff (-NR₂²) oder Sauerstoff- (-OR²) gebunden sind, Alkyl-(linear, verzweigt oder zyklisch), Heteroalkyl-, Aryl-, Heteroaryl-, Alkenyl-, Alkinyl-Gruppen oder substituierte Alkyl- (linear, verzweigt oder zyklisch), Heteroalkyl-, Aryl-, Heteroaryl- und Alkenyl-Gruppen mit Substituenten wie Halogene oder Deuterium, Alkylgruppen (linear, verzweigt oder zyklisch);
- R²: ist bei jedem Auftreten gleich oder verschieden Wasserstoff, Deuterium, Alkyl- (linear, verzweigt oder zyklisch), Heteroalkyl-, Aryl-, Heteroaryl-, Alkenyl-, Alkinyl-Gruppen oder substituierte Alkyl- (linear, verzweigt oder zyklisch), Heteroalkyl-, Aryl-, Heteroaryl- und Alkenyl-Gruppen mit Substituenten wie Halogene oder Deuterium, Alkylgruppen (linear, verzweigt oder zyklisch);
- R³: ist bei jedem Auftreten gleich oder verschieden H, D, OR⁵, SR⁵ oder C(R⁵)₃;
- R⁵: ist bei jedem Auftreten gleich oder verschieden Wasserstoff, eine Alkylgruppe oder eine Arylgruppe;
und wobei die Verknüpfung mit der Akzeptorgruppe W₅N jeweils an der mit # gekennzeichneten Stelle in Form einer Einfachbindung stattfindet.

In einer alternativen Ausführungsform der Erfindung ist X eine bivalente organische Brücke ausgewählt aus der Gruppe bestehend aus substituierten und unsubstituierten Alkylen-(linear, verzweigt oder zyklisch), Alkenylen-, Alkinylen-, Arylen- und Heteroarylen-Gruppen, O, NR³, C=CR³₂, C=NR³, SiR³₂ S, S(O), S(O)₂, BR³, PR³, P(O)R³, wobei auch Kombinationen dieser Einheiten möglich sind (z.B. durch O unterbrochene Alkylen- (linear,verzweigt oder zyklisch), Alkenylen-, Alkinylen-, Arylen- und Heteroarylen-Gruppen).

In einer weiteren alternativen Ausführungsform ist Y eine kovalente Einfachbindung oder eine bivalente organische Brücke ausgewählt aus der Gruppe bestehend aus substituierten und unsubstituierten Alkylen- (linear, verzweigt oder zyklisch), Alkenylen-, Alkinylen-, Arylen-und Heteroarylen-Gruppen, O, NR³, C=CR³₂, C=NR³, SiR³₂ S, S(O), S(O)₂, BR³, PR³, P(O)R³, wobei auch Kombinationen dieser Einheiten möglich sind (z.B. durch O unterbrochene Alkylen- (linear, verzweigt oder zyklisch), Alkenylen-, Alkinylen-, Arylen- und Heteroarylen-Gruppen).

Erfindungsgemäß ist auch die alternative Ausführungsform, in der R¹ bei jedem Auftreten gleich oder verschieden H, D, F, Cl, Br, I, B(OR³)₂, CHO, C(=O)R³, CR³=C(R³)₂, CN, C(=O)OR³, C(=O)N(R³)₂, Si(R³)₃, NO₂, P(=O)(R³)₂, OSO₂R³, OR³, S(=O)R³, S(=O)₂R³, eine geradkettige Alkyl-, Alkoxy- oder Thioalkylgruppe mit 1 bis 20 C-Atomen oder eine verzweigte oder cyclische Alkyl-, Alkoxy- oder Thioalkylgruppe mit 3 bis 20 C-Atomen oder eine Alkenyl- oder Alkinylgruppe mit 2 bis 20 C-Atomen ist, wobei die oben genannten Gruppen jeweils mit einem oder mehreren Resten R³ substituiert sein können und wobei eine oder mehrere CH₂- Gruppen in den oben genannten Gruppen durch -R³C=CR³-, -C=C-, Si(R³)₂, C=O, C=S, C=NR³, -C(=O)O-, -C(=O)NR³-, NR³, P(=O)(R³), -O-, -S-, SO oder SO₂ ersetzt sein können und wobei ein oder mehrere H-Atome in den oben genannten Gruppen durch D, F, Cl, Br, I, CN oder NO₂ ersetzt sein können, oder ein aromatisches Ringsystem mit 6 bis 30 aromatischen Ringatomen, das jeweils durch einen oder mehrere Reste R³ substituiert sein kann, oder eine Aryloxygruppe mit 6 bis 30 aromatischen Ringatomen, die durch einen oder mehrere Reste R³ substituiert sein kann, wobei zwei oder mehr Reste R¹ miteinander verknüpft sein können und einen Ring bilden können.

In einer alternativen Ausführungsform ist R² bei jedem Auftreten gleich oder verschieden H, D, F, Cl, Br, I, B(OR³)_{2>} CHO, C(=O)R³, CR³=C(R³)₂, CN, C(=O)O_{R}³, C(=O)N(R³)₂₎ Si(R³)₃, N(R³)₂, NO₂, P(=O)(R³)₂, OSO₂R³, OR³, S(=O)R³, S(=O)₂R³, eine geradkettige Alkyl-, Alkoxy-oder Thio- alkylgruppe mit 1 bis 20 C-Atomen oder eine verzweigte oder cyclische Alkyl-, Alkoxy- oder Thioalkylgruppe mit 3 bis 20 C- Atomen oder eine Alkenyl- oder Alkinylgruppe mit 2 bis 20 C- Atomen, wobei die oben genannten Gruppen jeweils mit einem oder mehreren Resten R³ substituiert sein können und wobei eine oder mehrere CH₂-Gruppen in den oben genannten Gruppen durch -R³C=CR³-, -C=C-, Si(R³)₂, C=O, C=S, C=NR³, - C(=O)O-, -C(=O)NR³-, NR³, P(=O)(R³), -O-, -S-, SO oder SO₂ ersetzt sein können und wobei ein oder mehrere H-Atome in den oben genannten Gruppen durch D, F, Cl, Br, I, CN oder NO₂ ersetzt sein können, oder ein aromatisches oder heteroaromatisches Ringsystem mit 5 bis 30 aromatischen Ringatomen, das jeweils durch einen oder mehrere Reste R³ substituiert sein kann, oder eine Aryloxy- oder Heteroaryloxygruppe mit 5 bis 60 aromatischen Ringatomen, die durch einen oder mehrere Reste R³ substituiert sein kann.

In einer alternativen Ausführungsform ist R³bei jedem Auftreten gleich oder verschieden H, D, F, Cl, Br, I, B(OR⁴)₂, CHO, C(=O)R⁴, CR⁴=C(R⁴)₂, CN, C(=O)OR⁴, C(=O)N(R⁴)₂, Si(R⁴)₃, N(R⁴)₂, NO₂, P(=O)(R⁴)₂, OSO₂R⁴, OR⁴, S(=O)R⁴, S(=O)₂R⁴, eine geradkettige Alkyl-, Alkoxy-oder Thioalkylgruppe mit 1 bis 20 C-Atomen oder eine verzweigte oder cyclische Alkyl-, Alkoxy- oder Thioalkylgruppe mit 3 bis 20 C- Atomen oder eine Alkenyl- oder Alkinylgruppe mit 2 bis 20 C- Atomen, wobei die oben genannten Gruppen jeweils mit einem oder mehreren Resten R⁴ substituiert sein können und wobei eine oder mehrere CH₂-Gruppen in den oben genannten Gruppen durch -R⁴C=CR⁴-, -C=C-, Si(R⁴)₂, C=O, C=S, C=Se, C=NR⁴, - C(=O)O-, -C(=O)NR⁴-, NR⁴, P(=O)(R⁴), -O-, -S-, SO oder SO₂ ersetzt sein können und wobei ein oder mehrere H-Atome in den oben genannten Gruppen durch D, F, Cl, Br, I, CN oder NO₂ ersetzt sein können, oder ein aromatisches oder heteroaromatisches Ringsystem mit 5 bis 60 aromatischen Ringatomen, das jeweils durch einen oder mehrere Reste R⁴ substituiert sein kann, oder eine Aryloxy- oder Heteroaryloxygruppe mit 5 bis 60 aromatischen Ringatomen, die durch einen oder mehrere Reste R⁴ substituiert sein kann, wobei zwei oder mehr Reste R³ miteinander verknüpft sein können und einen Ring bilden können.
R⁴ ist bei jedem Auftreten gleich oder verschieden H, D, OR⁵, SR⁵ oder C(R⁵)₃.

In einer weiteren alternativen Ausführungsform ist R⁴ bei jedem Auftreten gleich oder verschieden H, D, F oder ein aliphatischer, aromatischer oder heteroaromatischer organischer Rest mit 1 bis 20 C-Atomen, in dem auch ein oder mehrere H-Atome durch D oder F ersetzt sein können; dabei können zwei oder mehr Substituenten R⁴ miteinander verknüpft sein und einen Ring bilden.

Die Erfindung betrifft in einer Ausführungsform organische Moleküle mit einer Struktur der Formeln 3a bis 3m. 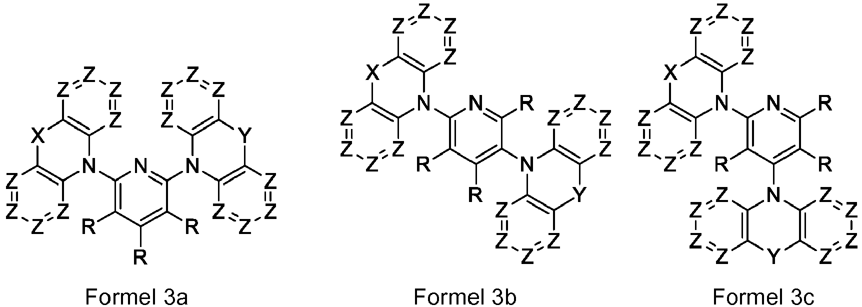 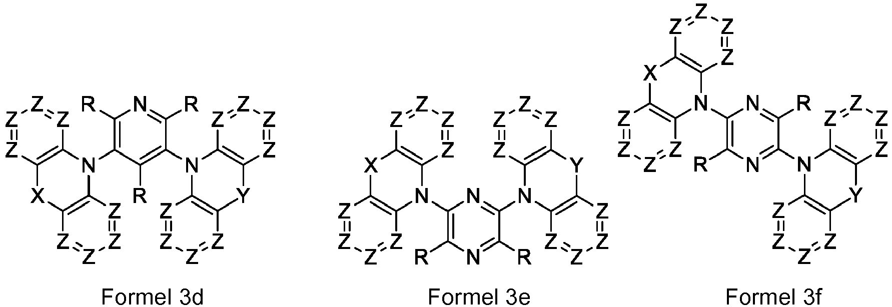 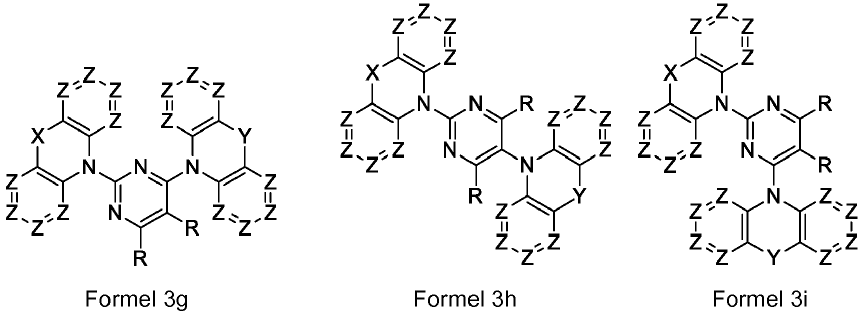 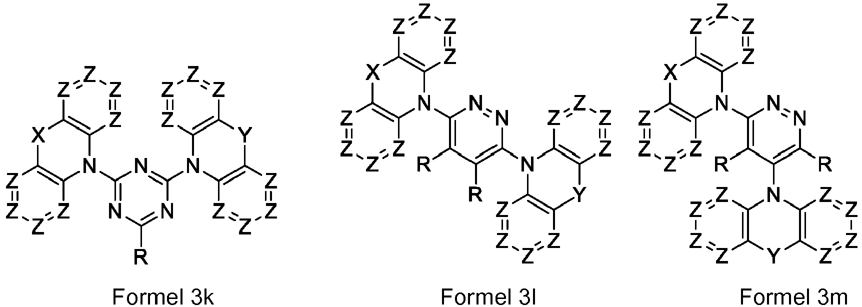 mit
- X: ist gleich oder verschieden eine bivalente Brücke ausgewählt aus O, S, S=O, SO₂, Se, Se=O, SeO₂, C(R³)₂, C=NR³, C=C(R³)₂, Si(R³)₂, N(R³), P(R³), P(=O)R³ oder B(R³);
- Y: ist bei jedem Auftreten gleich oder verschieden eine kovalente Einfachbindung oder eine bivalente Brücke ausgewählt aus O, S, S=O, SO₂, Se, Se=O, SeO₂, C(R³)₂, C=NR³, C=C(R³)₂, Si(R³)₂, N(R³), P(R³), P(=O)R³ oder B(R³);
wobei X und Y verschieden zueinander sein müssen;
- Z: ist bei jedem Auftreten gleich oder verschieden CR² oder N;
- R: ist bei jedem Auftreten gleich oder verschieden Wasserstoff, Halogen, Deuterium, Gruppen, die über Stickstoff (-NR₂²) oder Sauerstoff- (-OR²) gebunden sind, Alkyl-(linear, verzweigt oder zyklisch), Heteroalkyl-, Aryl-, Heteroaryl-, Alkenyl-, Alkinyl-Gruppen oder substituierte Alkyl- (linear, verzweigt oder zyklisch), Heteroalkyl-, Aryl-, Heteroaryl- und Alkenyl-Gruppen mit Substituenten wie Halogene oder Deuterium, Alkylgruppen (linear, verzweigt oder zyklisch);
- R²: ist bei jedem Auftreten gleich oder verschieden Wasserstoff, Deuterium, Alkyl- (linear, verzweigt oder zyklisch), Heteroalkyl-, Aryl-, Heteroaryl-, Alkenyl-, Alkinyl-Gruppen oder substituierte Alkyl- (linear, verzweigt oder zyklisch), Heteroalkyl-, Aryl-, Heteroaryl- und Alkenyl-Gruppen mit Substituenten wie Halogene oder Deuterium, Alkylgruppen (linear, verzweigt oder zyklisch);
- R³: ist bei jedem Auftreten gleich oder verschieden H, D, OR⁵, SR⁵ oder C(R⁵)₃;
- R⁵: ist bei jedem Auftreten gleich oder verschieden Wasserstoff, eine Alkylgruppe oder eine Arylgruppe.

In einer alternativen Ausführungsform der Erfindung ist X eine bivalente organische Brücke ausgewählt aus der Gruppe bestehend aus substituierten und unsubstituierten Alkylen-(linear, verzweigt oder zyklisch), Alkenylen-, Alkinylen-, Arylen- und Heteroarylen-Gruppen, O, NR³, C=CR³₂, C=NR³, SiR³₂ S, S(O), S(O)₂, BR³, PR³, P(O)R³, wobei auch Kombinationen dieser Einheiten möglich sind (z.B. durch O unterbrochene Alkylen- (linear,verzweigt oder zyklisch), Alkenylen-, Alkinylen-, Arylen- und Heteroarylen-Gruppen).

In einer weiteren alternativen Ausführungsform ist Y eine kovalente Einfachbindung oder eine bivalente organische Brücke ausgewählt aus der Gruppe bestehend aus substituierten und unsubstituierten Alkylen- (linear, verzweigt oder zyklisch), Alkenylen-, Alkinylen-, Arylen-und Heteroarylen-Gruppen, O, NR³, C=CR³₂, C=NR³, SiR³₂ S, S(O), S(O)₂, BR³, PR³, P(O)R³, wobei auch Kombinationen dieser Einheiten möglich sind (z.B. durch O unterbrochene Alkylen- (linear, verzweigt oder zyklisch), Alkenylen-, Alkinylen-, Arylen- und Heteroarylen-Gruppen).

Erfindungsgemäß ist auch die alternative Ausführungsform, in der R bei jedem Auftreten gleich oder verschieden H, D, F, Cl, Br, I, B(OR³)₂, CHO, C(=O)R³, CR³=C(R³)₂, CN, C(=O)OR³, C(=O)N(R³)₂, Si(R³)₃, NO₂, P(=O)(R³)₂, OSO₂R³, OR³, S(=O)R³, S(=O)₂R³, eine geradkettige Alkyl-, Alkoxy- oder Thioalkylgruppe mit 1 bis 20 C-Atomen oder eine verzweigte oder cyclische Alkyl-, Alkoxy- oder Thioalkylgruppe mit 3 bis 20 C-Atomen oder eine Alkenyl- oder Alkinylgruppe mit 2 bis 20 C-Atomen ist, wobei die oben genannten Gruppen jeweils mit einem oder mehreren Resten R³ substituiert sein können und wobei eine oder mehrere CH₂- Gruppen in den oben genannten Gruppen durch -R³C=CR³-, -C=C-, Si(R³)₂, C=O, C=S, C=NR³, -C(=O)O-, -C(=O)NR³-, NR³, P(=O)(R³), -O-, -S-, SO oder SO₂ ersetzt sein können und wobei ein oder mehrere H-Atome in den oben genannten Gruppen durch D, F, Cl, Br, I, CN oder NO₂ ersetzt sein können, oder ein aromatisches Ringsystem mit 6 bis 30 aromatischen Ringatomen, das jeweils durch einen oder mehrere Reste R³ substituiert sein kann, oder eine Aryloxygruppe mit 6 bis 30 aromatischen Ringatomen, die durch einen oder mehrere Reste R³ substituiert sein kann, wobei zwei oder mehr Reste R miteinander verknüpft sein können und einen Ring bilden können.

In einer alternativen Ausführungsform ist R² bei jedem Auftreten gleich oder verschieden H, D, F, Cl, Br, I, B(OR³)_{2>} CHO, C(=O)R³, CR³=C(R³)₂, CN, C(=O)OR³, C(=O)N(R³)₂₎ Si(R³)₃, N(R³)₂, NO₂, P(=O)(R³)₂, OSO₂R³, OR³, S(=O)R³, S(=O)₂R³, eine geradkettige Alkyl-, Alkoxy-oder Thio- alkylgruppe mit 1 bis 20 C-Atomen oder eine verzweigte oder cyclische Alkyl-, Alkoxy- oder Thioalkylgruppe mit 3 bis 20 C- Atomen oder eine Alkenyl- oder Alkinylgruppe mit 2 bis 20 C- Atomen, wobei die oben genannten Gruppen jeweils mit einem oder mehreren Resten R³ substituiert sein können und wobei eine oder mehrere CH₂-Gruppen in den oben genannten Gruppen durch -R³C=CR³-, -C=C-, Si(R³)₂, C=O, C=S, C=NR³, - C(=O)O-, -C(=O)NR³-, NR³, P(=O)(R³), -O-, -S-, SO oder SO₂ ersetzt sein können und wobei ein oder mehrere H-Atome in den oben genannten Gruppen durch D, F, Cl, Br, I, CN oder NO₂ ersetzt sein können, oder ein aromatisches oder heteroaromatisches Ringsystem mit 5 bis 30 aromatischen Ringatomen, das jeweils durch einen oder mehrere Reste R³ substituiert sein kann, oder eine Aryloxy- oder Heteroaryloxygruppe mit 5 bis 60 aromatischen Ringatomen, die durch einen oder mehrere Reste R³ substituiert sein kann.

In einer alternativen Ausführungsform ist R³bei jedem Auftreten gleich oder verschieden H, D, F, Cl, Br, I, B(OR⁴)₂, CHO, C(=O)R⁴, CR⁴=C(R⁴)₂, CN, C(=O)OR⁴, C(=O)N(R⁴)₂, Si(R⁴)₃, N(R⁴)₂, NO₂, P(=O)(R⁴)₂, OSO₂R⁴, OR⁴, S(=O)R⁴, S(=O)₂R⁴, eine geradkettige Alkyl-, Alkoxy-oder Thioalkylgruppe mit 1 bis 20 C-Atomen oder eine verzweigte oder cyclische Alkyl-, Alkoxy- oder Thioalkylgruppe mit 3 bis 20 C- Atomen oder eine Alkenyl- oder Alkinylgruppe mit 2 bis 20 C- Atomen, wobei die oben genannten Gruppen jeweils mit einem oder mehreren Resten R⁴ substituiert sein können und wobei eine oder mehrere CH₂-Gruppen in den oben genannten Gruppen durch -R⁴C=CR⁴-, -C=C-, Si(R⁴)₂, C=O, C=S, C=Se, C=NR⁴, - C(=O)O-, -C(=O)NR⁴-, NR⁴, P(=O)(R⁴), -O-, -S-, SO oder SO₂ ersetzt sein können und wobei ein oder mehrere H-Atome in den oben genannten Gruppen durch D, F, Cl, Br, I, CN oder NO₂ ersetzt sein können, oder ein aromatisches oder heteroaromatisches Ringsystem mit 5 bis 60 aromatischen Ringatomen, das jeweils durch einen oder mehrere Reste R⁴ substituiert sein kann, oder eine Aryloxy- oder Heteroaryloxygruppe mit 5 bis 60 aromatischen Ringatomen, die durch einen oder mehrere Reste R⁴ substituiert sein kann, wobei zwei oder mehr Reste R³ miteinander verknüpft sein können und einen Ring bilden können.
R⁴ ist bei jedem Auftreten gleich oder verschieden H, D, OR⁵, SR⁵ oder C(R⁵)₃.

In einer weiteren alternativen Ausführungsform ist R⁴ bei jedem Auftreten gleich oder verschieden H, D, F oder ein aliphatischer, aromatischer oder heteroaromatischer organischer Rest mit 1 bis 20 C-Atomen, in dem auch ein oder mehrere H-Atome durch D oder F ersetzt sein können; dabei können zwei oder mehr Substituenten R⁴ miteinander verknüpft sein und einen Ring bilden.

Beispiele für Donorgruppen D1 und D2 im Sinne der Erfindung:
# = Anbindungsposition für Akzeptoren A; q gleich 1 bis 4; die Reste R und R₁ sind bei jedem Auftreten gleich oder verschieden Wasserstoff, Halogen, Deuterium, Gruppen, die über Stickstoff (-NR₂²) oder Sauerstoff- (-OR²) gebunden sind, Alkyl- (auch verzweigt oder zyklisch), Heteroalkyl-, Aryl-, Heteroaryl-, Alkenyl-, Alkinyl-Gruppen oder substituierte Alkyl- (auch verzweigt oder zyklisch), Heteroalkyl-, Aryl-, Heteroaryl- und Alkenyl-Gruppen mit Substituenten wie Halogene oder Deuterium, Alkylgruppen (auch verzweigt oder zyklisch). Die Liste ist nicht erschöpfend gemeint und schließt keine Donoren aus.

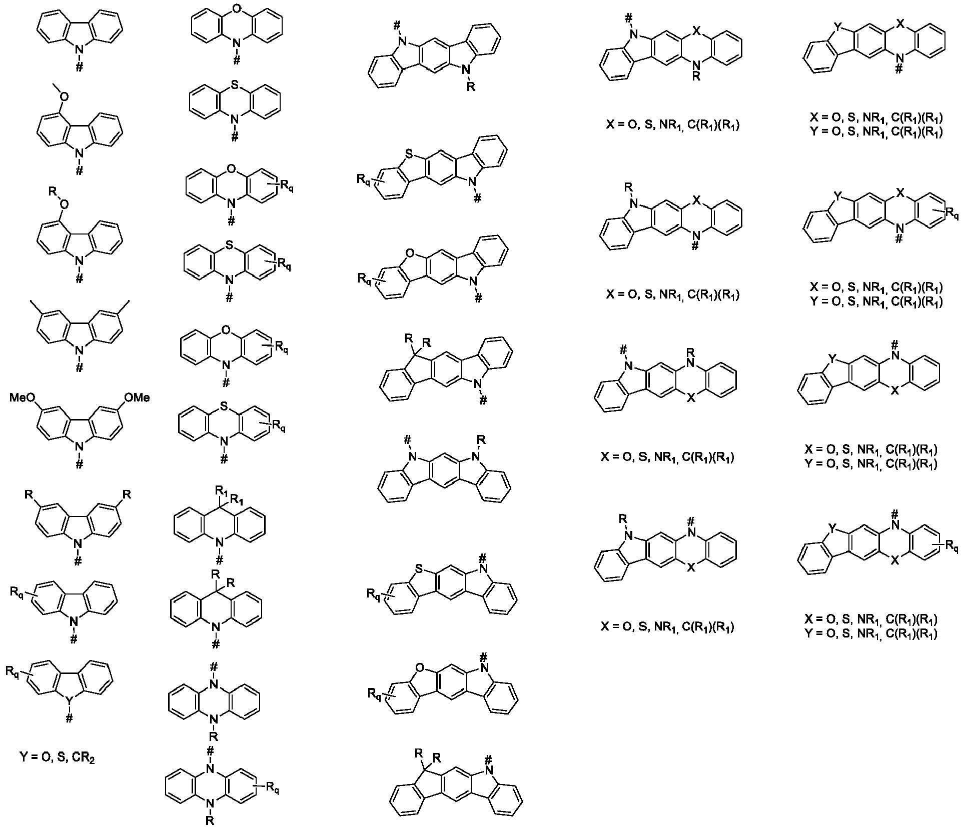

Beispiele für Akzeptorgruppe:
# = Anbindungsposition für Donoren D1/D2; q gleich 1 bis 4; die Reste R und Rest R₁ sind bei jedem Auftreten gleich oder verschieden Wasserstoff, Halogen, Deuterium, Gruppen, die über Stickstoff (-NR₂²) oder Sauerstoff- (-OR²) gebunden sind, Alkyl- (auch verzweigt oder zyklisch), Heteroalkyl-, Aryl-, Heteroaryl-, Alkenyl-, Alkinyl-Gruppen oder substituierte Alkyl- (auch verzweigt oder zyklisch), Heteroalkyl-, Aryl-, Heteroaryl- und Alkenyl-Gruppen mit Substituenten wie Halogene oder Deuterium, Alkylgruppen (auch verzweigt oder zyklisch. Die Liste ist nicht erschöpfend gemeint und schließt keine Akzeptoren aus.

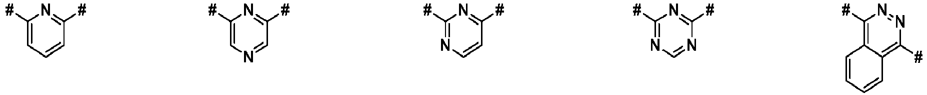

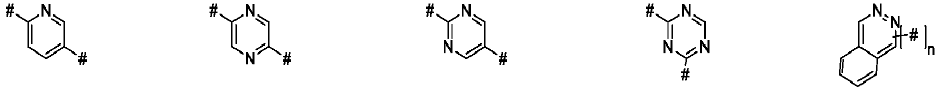

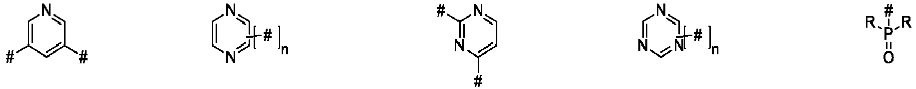

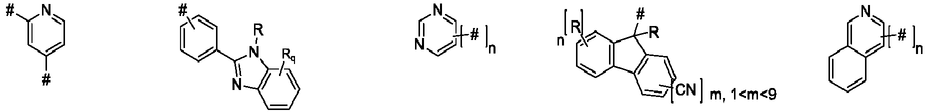

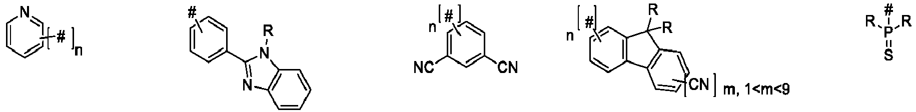

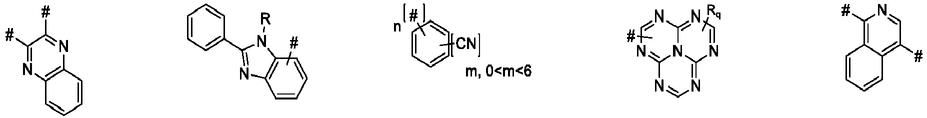

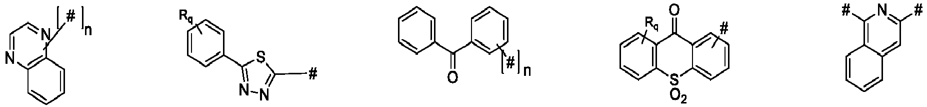

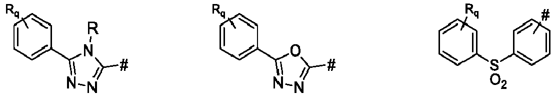

In einem weiteren Aspekt betrifft die Erfindung ein Verfahren zur Herstellung eines hierin beschriebenen organischen Moleküls. Dieses erfindungsgemäße Verfahren weist den Schritt des Durchführens einer Reaktion von einem Difluor-substituiertem Derivat von A mit D1 und D2 auf,
mit
A = eine Akzeptorgruppe mit elektronenziehenden Eigenschaften unabhängig voneinander ausgewählt aus der Gruppe bestehend aus Pyridin, Pyridazin, Pyrimidin, Pyrazin, Triazin, Oxazol, Thiazol, Imidazol, Pyrazol, Isoxazol, Isothiazol, 1,2,3-Triazol, 1,2,4-Triazol, 1,2,4-Oxadiazol, 1,2,4-Thiadiazol, Tetrazol, 1,2,3,4-Oxatriazol, 1,2,3,4-Thiatriazol, die mit einem oder mehreren Resten R¹ substituiert sein können, wobei zwei oder mehr Reste R¹ miteinander verknüpft sein können und einen Ring bilden können, P(=O)R¹₂, P(=O)R¹, P(=S)R¹₂, P(=S)R¹, P(=Se)R¹₂, P(=Se)R¹, SO₂, Benzimidazol, Benzoxazol, Benzothiazol;
D1 = eine Donorgruppe mit elektronenschiebenden Eigenschaften, aufweisend eine Struktur der Formel 1a; 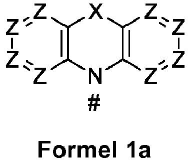 D2 = eine Donorgruppe mit elektronenschiebenden Eigenschaften, aufweisend eine Struktur der Formel 1b; 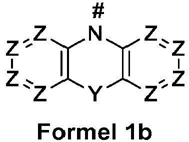 wobei die Verknüpfung mit A jeweils an der mit # gekennzeichneten Stelle in Form einer Einfachbindung stattfindet;
und wobei die weiteren Symbole die oben angegebenen Bedeutungen haben.

Die Reaktion wird insbesonder unter Zugabe einer starken Base durchgeführt. Zur Darstellung der Akzeptoreinheiten P(=O)R¹₂ oder P(=O)R¹ wird die Reaktion in einer weiteren Ausführungsform unter darauffolgender Zugabe eines Oxidationsmittels unabhängig voneinander ausgewählt aus der Gruppe aus Wasserstoffperoxid, Wasserstoffperoxid-Harnstoff-Addukt, Sauerstoff oder Ozon durchgeführt. Zur Darstellung der Akzeptoreinheiten P(=S)R¹₂, P(=S)R¹, P(=Se)R¹₂ oder P(=Se)R¹ erfolgt zudem die weitere Umsetzung mit Schwefel oder Lawessons Reagenz bzw. mit Selen.

Beispielhaft lassen sich folgende zwei allgemeine Syntheserouten formulieren:

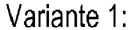

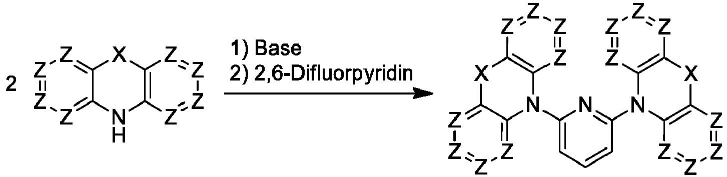

Dieses Verfahren kommt so oder in vergleichbarer Art zum Einsatz, wenn Pyridin, Triazin, Pyrimidin, Benzimidazol, 1,2,4-oxadiazol, 1,2,4-triazol, oder 1,2,3-Triazol als Akzeptoreinheit A gewählt werden. Dem Fachmann ist hierbei bekannt, welche Substituenten an der Akzeptoreinheit jeweils zur Umsetzung mit der Donoreinheit geeignet sind. Zur Erreichung der erfindungsgemäßen unsymmetrischen Moleküle müssen entweder Mischungen aus verschiedenen Donoreinheiten eingesetzt werden oder die Einführung der Reste D1 und D2 sequentiell erfolgen, unter Isolierung des Mono-fluor-mono-Donor-substituierten Intermediates oder im Eintopfverfahren.

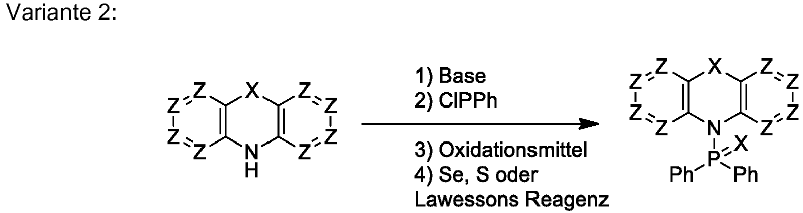

Dieses Verfahren kommt bis zu Schritt 3) zum Einsatz, wenn P(=O)R⁴₂ oder P(=O)_{R}⁴ als Akzeptoreinheit A gewählt werden. Im Falle von P(=S)R⁴₂, P(=S)R⁴ bzw. P(=Se)R⁴₂, P(=Se)R⁴ werden alle vier Schritte durchgeführt. Dem Fachmann ist hierbei bekannt, welche Substituenten an der Akzeptoreinheit jeweils zur Umsetzung mit der Donoreinheit geeignet sind.

Ein weiterer Aspekt der vorliegenden Erfindung betrifft die Verwendung eines organischen Moleküls der hierin beschriebenen Art in einer emittierenden Schicht als Matrixmaterial (Hostmaterial) für lumineszierende Emitter und/oder als Elektronentransportmaterial und/oder als Lochinjektionsmaterial und/oder als Lochblockiermaterial in einem optoelektronischen Bauelement.

In einer Ausführungsform der Erfindung wird das organische Molekül der hierin beschriebenen Art in einer emittierenden Schicht eines optoelektronischen Bauelementes, insbesonder in Mischung mit mindestens einer weiteren Verbindung verwendet. Hierbei ist das organische Molekül der hierin beschriebenen Art in der Mischung insbesondere das Matrixmaterial ist.

In einer Ausführungsform der Erfindung wird ein organisches Molekül der hierin beschriebenen Art entsprechend als Matrixmaterial für lumineszierende Emitter in einem optoelektronischen Bauelement eingesetzt.

Ein optoelektronisches Bauelement gemäß der vorliegenden Erfindung ist insbesondere ausgewählt aus der Gruppe bestehend aus:
- Organischen Licht-emittierenden Bauteilen (OLEDs),
- Licht-emittierenden elektrochemischen Zellen,
- OLED-Sensoren, insbesondere in nicht hermetisch nach außen abgeschirmten Gas- und Dampf-Sensoren,
- organischen Solarzellen,
- Organischen Feldeffekttransistoren,
- Organischen Lasern und
- Down-Konversions-Elementen.

Ein weiterer Erfindungsaspekt betrifft Mischungen, enthaltend mindestens ein organisches Molekül der hierin beschriebenen Art und mindestens einen lumineszierenden Emitter.

In einem weiteren Aspekt betrifft die Erfindung Formulierungen enthaltend mindestens ein organisches Molekül der hierin beschriebenen Art oder eine hier beschriebene Mischung und mindestens ein Lösemittel.

In einer Ausführungsform beträgt der Anteil des organischen Materials als Matrixmaterial in optischen lichtemittierenden Bauelementen, insbesondere in OLEDs, zwischen 50 % und 99 %.

In einem weiteren Aspekt betrifft die Erfindung ein optoelektronisches Bauelement aufweisend ein organisches Molekül der hierin beschriebenen Art. Hierbei enthält ein erfindungsgemäßes optoelektronisches Bauelement mindestens eine Schicht zwischen Anode und Kathode, die ein organisches Molekül der hierin beschriebenen Art beispielsweise als Matrixmaterial (Hostmaterial) für lumineszierende Emitter und/oder als Elektronentransportmaterial und/oder als Lochinjektionsmaterial und/oder als Lochblockiermaterial enthält. Hierbei kann das optoelektronische Bauelement ausgewählt sein aus der Gruppe bestehend aus organischem lichtemittierendem Bauelement, organischer Diode, organischer Solarzelle, organischem Transistor, organischer Licht-emittierender Diode, Licht-emittierender elektrochemischer Zelle, organischem Feldeffekttransistor und organischem Laser.

In einem weiteren Aspekt betrifft die Erfindung ein Verfahren zur Herstellung eines optoelektronischen Bauelements, wobei ein organisches Molekül der hierin beschriebenen Art verwendet wird.

Teil eines derartigen Verfahrens kann das Aufbringen eines erfindungsgemäßen organischen Moleküls auf einen Träger sein. Das Aufbringen kann optional durch Verdampfung im Vakuum oder nass-chemisch erfolgen.

Die hierfür gängigen Verfahren sind dem Fachmann bekannt und können von ihm auf optoelektronische Bauelemente enthaltend ein organisches Molekül der hierin beschriebenen Art angewandt werden.

Die erfindungsgemäßen organischen Moleküle weisen bei Verwendung in optoelektronischen Bauteilen folgende überraschende Vorteile gegenüber dem Stand der Technik auf:
a. Die Ladungsträgermobilität im Bauteil wird verbessert im Vergleich zu Systemen gemäß dem Stand der Technik.
b. Die Effizienz der Bauteile ist höher im Vergleich zu Systemen gemäß dem Stand der Technik.
c. Die Stabilität der Bauteile ist höher im Vergleich zu Systemen gemäß dem Stand der Technik.
d. Die Lebensdauer der Bauteile ist höher im Vergleich zu Systemen gemäß dem Stand der Technik.

Im vorliegenden Anmeldetext und in den im Weiteren folgenden Beispielen wird in erster Linie auf die Verwendung der erfindungsgemäßen organischen Moleküle in OLEDs und den entsprechenden Displays und Beleuchtungselementen verwiesen. Trotzdem ist es dem Fachmann ohne erfinderisches Zutun möglich, die organischen Moleküle der hierin beschriebenen Art auch für weitere Verwendungen in anderen optoelektronischen Bauelementen einzusetzen.

Durch die nachfolgenden Beispiele wird die Erfindung näher erläutert, ohne sie dadurch einschränken zu wollen.

### Beispiele

### Beispiel 1: 2,carbazoyl-6- (1-phenothiazinyl)-pyrimidin)

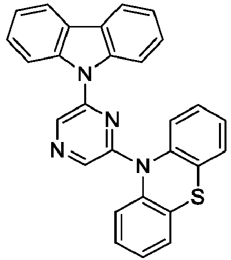

### Beispiel 2:

### 2,carbazoyl-6- (1-phenoxazinyl)-pyrimidin)

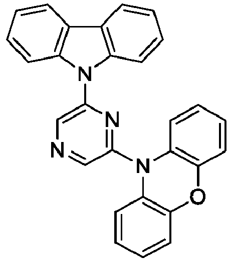

### Beispiel 3

### 2,4,-biscarbazoyl-6-(1-phenothiazinyl)-triazin)

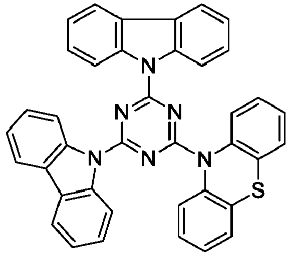

### Beispiel 4

### 2, carbazoyl-4,6-bis-(1-phenothiazinyl)-triazin)

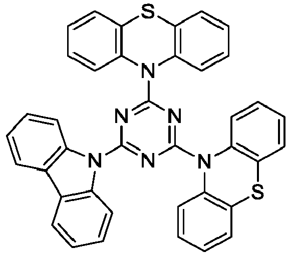

### Beispiel 5: 2-N-phenothiazinyl-6-N-(3,6-bis-tBu-carbazoyl)-pyridin

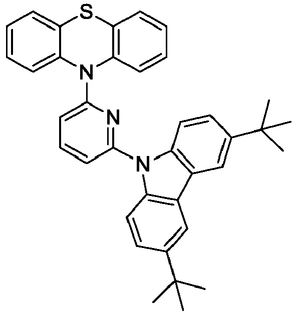

*2-N-phenothiazinyl-6-N-(3,6-bis-tBu-carbazoyl)-pyridin:* Die Verbindung kann durch stufenweise Substitution oder einer Eintopf-Substitution dargestellt werden.

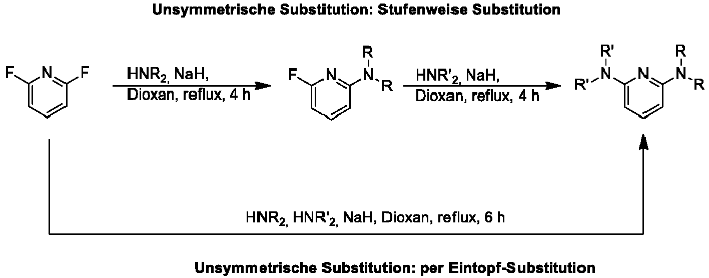

Stufenweise Substitution: erster Substitutionsschritt:

Das Carbazolderivat (10 mmol, 1.00 Äquiv.) wird mit Natriumhydrid (60% mit Paraffin, 500 mg, 13 mmol, 1.3 Äquiv.) versetzt und unter Stickstoff portionsweise mit insgesamt 110 mL Dioxan gelöst. Die Zugabegeschwindigkeit wird dabei an die Wasserstoffbildung angepasst um ein Überschäumen zu vermeiden. Nach vollständiger Zugabe wurde die Reaktion für 15 min bei r.t. gerührt und anschließend für 15 min unter Rückfluss erhitzt. 2,6-Difluorpyridin (1.15 g, 10 mmol, 1.00 Äquiv.) wird tropfenweise zur Reaktionsmischung zugegeben. Dabei schwächt sich die Fluoreszenz unter UV-Licht merklich ab. Die Reaktionsmischung wird bis zu vollständigem Umsatz der Edukte (Reaktionskontrolle per HPLC, GC-MS oder DC; typischerweise 4 h) am Rückfluss erhitzt. Nach Abkühlen auf Raumtemperaturwird überschüssige Base durch tropfenweise Zugabe von 10 mL Wasser unter Stickstoff gequencht. Die Reaktionsmischung wurde in 200 mL gesättigte Natriumchloridlösung gegeben und das Rohprodukt durch Absaugen abgetrennt und mit Wasser (300 mL) sowie Methanol (60 mL) gewaschen. Der so erhaltene Feststoff wurde mit 200 mL heißem Toluol digeriert und der unlösliche Rückstand verworfen. Das Lösungsmittel wurde unter vermindertem Druck entfernt und das Produkt wurde mit Pentan (300 mL) und Diethylether (200 mL) gewaschen und am Vakuum getrocknet. Das Produkt wurde als beigefarbener Feststoff isoliert und in der Regel ohne weitere Aufreinigung weiter umgesetzt. Analysenreines Produkt konnte durch Vakuumsublimation bei 250 °C, 0.002 mbar beziehungsweise durch MPLC-Aufreinigung (Laufmittelgradient Cyclohexan - Dichlormethan) erhalten werden.

Stufenweise Substitution: zweiter Substitutionssschritt:

Die Synthese, die Substitution mit 1H-Phenothiazin erfolgte analog zum ersten Schritt. Die Aufreinigung erfolgte mittels MPLC (Laufmittelgradient Cyclohexan - Dichlormethan).

Eintopf-Synthese:
Eine 1:1 Mischung der beiden Verbindungen NHR₂ und NHR'₂ (20 mmol, 2.00 Äquiv.) wird mit Natriumhydrid (60 % mit Paraffin, 1.00 g, 26 mmol, 2.6 Äquiv.) versetzt und unter Stickstoff portionsweise mit insgesamt 250 mL Dioxan gelöst. Die Zugabegeschwindigkeit wird dabei an die Wasserstoffbildung angepasst um ein Überschäumen zu vermeiden. Nach vollständiger Zugabe wurde die Reaktion für 15 min bei Raumtemperatur gerührt und anschließend für 15 min unter Rückfluss erhitzt. 2,6-Difluorpyridin (1.15 g, 10 mmol, 1.00 Äquiv.) wird tropfenweise zur Reaktionsmischung zugegeben. Dabei schwächt sich die Fluoreszenz unter UV-Licht merklich ab. Die Reaktionsmischung wird bis zu vollständigem Umsatz der Edukte (Reaktionskontrolle per HPLC, GC-MS oder DC; typischerweise 6 h) am Rückfluss erhitzt. Nach Abkühlen auf Raumtemperatur wird überschüssige Base durch tropfenweise Zugabe von 10 mL Wasser unter Stickstoff gequencht. Die Reaktionsmischung wurde in 200 mL gesättigte Natriumchloridlösung gegeben und das Rohprodukt durch Absaugen abgetrennt und mit Wasser (300 mL) sowie Methanol (60 mL) gewaschen. Der so erhaltene Feststoff wurde mit 200 mL heißem Toluol digeriert und der unlösliche Rückstand verworfen. Das Lösungsmittel wurde unter vermindertem Druck entfernt und das Produkt wurde mit Pentan (300 mL) und Diethylether (200 mL) gewaschen und am Vakuum getrocknet. Zur Aufreinigung wurde das Produkt durch mehrfaches Umkristallisation bzw. in Einzelfällen durch Vakuumsublimation (Details siehe Einträge) aufgereinigt.

Beigefarbenes Pulver (87%). ¹H NMR (500 MHz, Chloroform-*d*) δ = 8.15 (d, *J* = 2.0 Hz, 2H), 7.79 (dd, *J* = 7.9, 1.4 Hz, 2H), 7.74 - 7.61 (m, 3H), 7.52 (dd, *J* = 7.7, 1.5 Hz, 2H), 7.41 (dd, *J* = 8.7, 2.0 Hz, 2H), 7.36 - 7.19 (m, 5H), 1.54 (s, 18H) ppm. - ¹³C NMR (126 MHz, Chloroform-*d*) δ = 156.7, 150.3, 143.6, 141.1, 139.6, 137.8, 133.5, 128.2, 128.1, 127.1, 126.0, 124.4, 123.6, 115.8, 112.0, 109.6, 105.6, 34.8, 32.0 ppm. - IR (ATR) 2951 (m), 1736 (s), 1568 (m), 1469 (m), 1429 (s), 1365 (s), 1307 (m), 1257 (m), 1227 (m), 1194 (m), 1162 (w), 1033 (w), 930 (w), 875 (w), 823 (w), 786 (m), 756 (m); 735 (m), 685 (w), 658 (w), 613 (w), 460 (w), 422 (vw) cm⁻¹. - FAB-MS (3-NBA) *m*/*z* (%): 538.3 [M⁺].

### Beispiel 6: Quantenmechanische Berechnungen

Zur Bestimmung der HOMO-/LUMO-Lagen wurden Dichtefunktionaltheorie-Rechnungen (DFT) unter Einsatz des BP86-Funktionals und der "resolution-of-identity"-Näherung sowie des def2-SV(P)-Basissatzes durchgeführt. Für die numerische Integration wurde das m4 grid verwendet.

### Beispiel 7: Cyclovoltammetrie

Cyclovoltammogramme von 10⁻³ molaren Lösungen der organischen Moleküle in Dichlormethan und Tetrabutylammoniumhexafluorophosphat (0.1 mol/l) als Leitelektrolyt wurden aufgenommen mit Hilfe eines Model 600D Series Electrochemical Analyzer mit Workstation (CH Instruments) bei einer Scanrate von 100 mV s⁻¹. Die Messungen wurden durchgeführt bei Raumtemperatur, unter Argon-Atmosphäre mit einer Dreielektroden-Anordnung (Arbeits- und Gegenelektrode: Pt-Wire. Referenzelektrode: Ag/AgCl) und kalibriert gegen FeCp₂/FeCp₂⁺ als internem Standard. HOMO- und LUMO-Daten wurden korrigiert mittels Ferrocen als internem Standard gegen SCE und nach folgenden Formeln berechnet (B. D'Andrade *et al.,* Organic Electronics 2005, *6*, 11.):
E_{CV-HOMO} = -(1.4 * 0.978 * (Ox/V - Ferrocen/V) + 4.6) eV
E_{CV-LUMO} = -(1.19 * (Red/V - Ferrocen/V) + 4.78) eV

### Beispiel 8: Kristallstruktur von 2,6-Bis-N-phenothiazinyl-pyridin

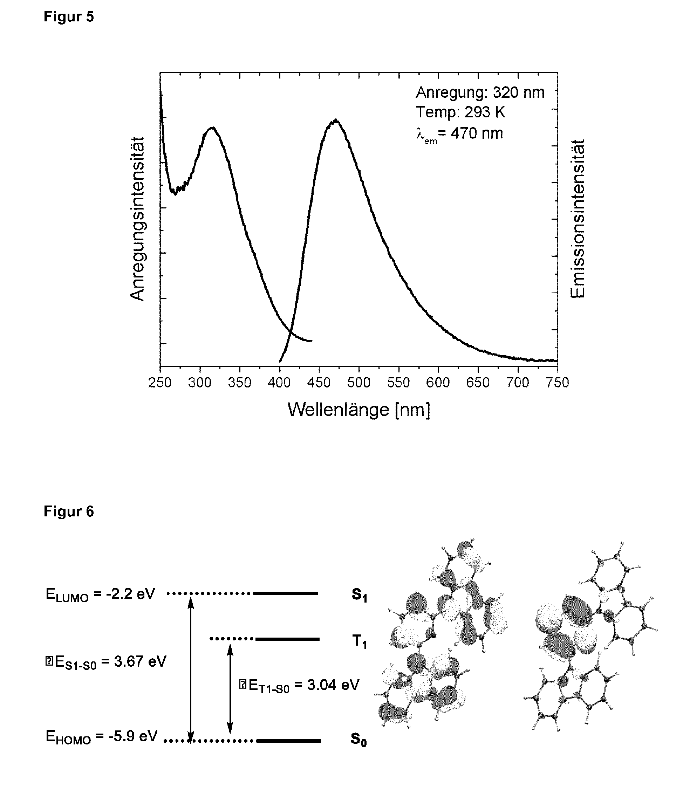

Wie aus der in Figur 6 dargestellten Kristallstruktur hervorgeht, sind durch die direkte Anknüpfung die Donoreinheit Phenothiazin und der Pyridinrest gegeneinander verdrillt. Diese Verdrillung mündet in eine hohe Triplett-Energie, insbesondere im Vergleich mit Molekülen des Stands der Technik, bei denen die Verdrillung schwächer ausgeprägt ist bzw. Spacer zwischen Donor und Pyridin (oder einem anderen, geeigneten Akzeptor wie Pyrimidin oder Triazin oder anderen) verwendet werden.

### Beispiel 9: Bestimmung und Vergleich der Triplett-Energie

Für die Berechnung der Host-Moleküle wurde Dichtefunktionaltheorie (DFT) unter Verwendung des BP86-Funktionals (Becke, A. D. Phys. Rev. A1988, 38, 3098-3100; Perdew, J. P. Phys. Rev. B1986, 33, 8822-8827) und des def2-SV(P)-Basissatzes (Weigend, F.; Ahlrichs, R. Phys. Chem. Chem. Phys. 2005, 7, 3297-3305; Rappoport, D.; Furche, F. J. Chem. Phys. 2010, 133, 134105/1-134105/11) verwendet. Zur numerischen Integration kam das m4-Grid zum Einsatz und die resolution-of-identity-Näherung (RI) wurde in allen Rechnungen verwendet. (Häser, M.; Ahlrichs, R. J. Comput. Chem. 1989, 10, 104-111; Weigend, F.; Häser, M. Theor. Chem. Acc. 1997, 97, 331-340; Sierka, M.; Hogekamp, A.; Ahlrichs, R. J. Chem. Phys. 2003, 118, 9136-9148). Die Grenzorbitale in diesem Beispiel wurden für die optimierten Grundzustandsgeometrien berechnet. Alle DFT-Rechnungen wurden mit dem Turbomole-Programmpaket (Version 6.5) durchgeführt (TURBOMOLE V6.5 2013, a development of University of Karlsruhe and Forschungszentrum Karlsruhe GmbH, 1989-2007, TURBOMOLE GmbH, since 2007; available from http://www.turbomole.com).

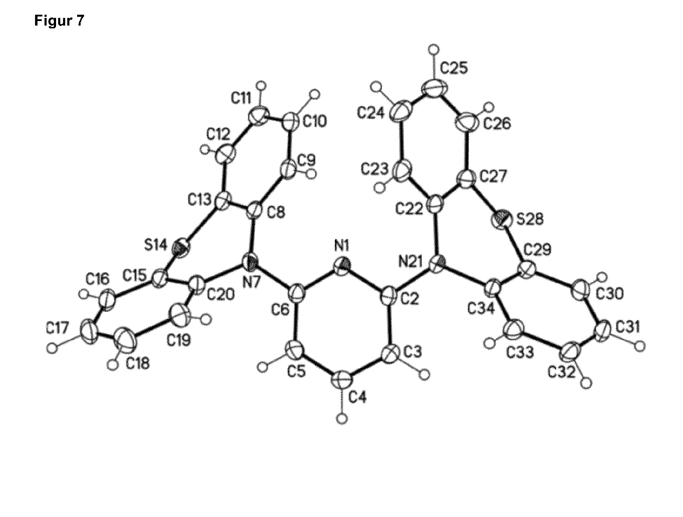

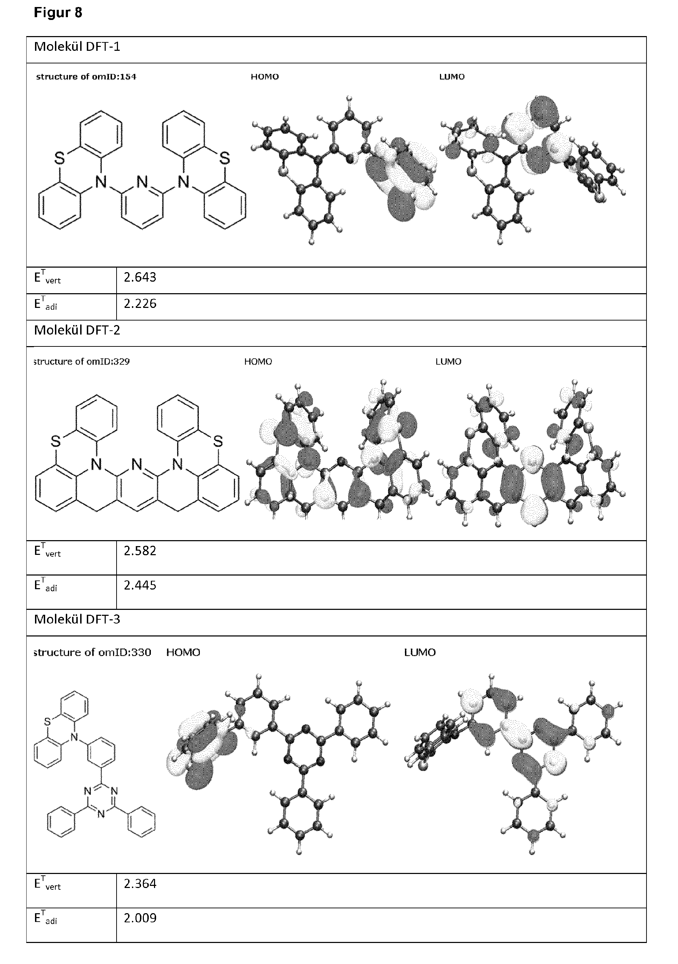

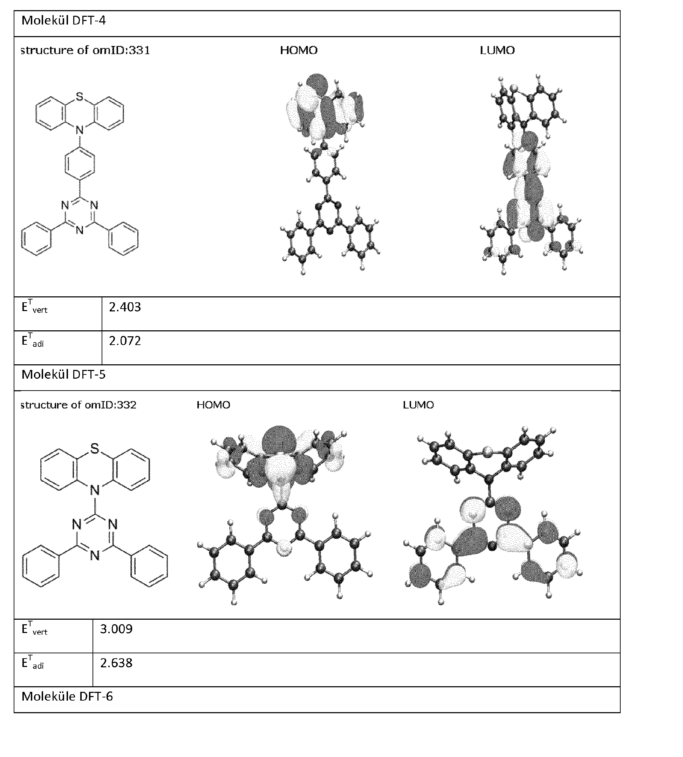

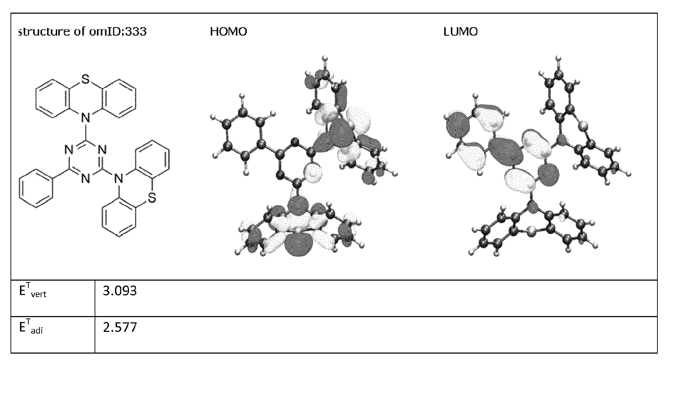

Die DFT-Ergebnisse sind in Figur 7 zusammengefasst.

Wie im vorangehenden Beispiel anhand von Röntgenkristallografieergebnissen gezeigt wurde, ergibt sich durch das erfindungsgemäße direkte verknüpfen der Erfindungsgemäßen sechsgliedrigen Donoreinheiten mit Akzeptoren wie Pyrimidin und Triazin aufgrund von sterischer Abstoßung eine relative Verdrillung dieser Einheiten. Dies verringert den Überlapp der Grenzorbitale HOMO und LUMO und sorgt für die gegenüber dem Stand der Technik vorteilhafte Erhöhung der Triplett-Energie.

Der Vergleich der Moleküle Molekül-DFT-1 und -2 aus diesem Beispiel zeigt den Vorteil der erfindungsgemäßen Verknüpfung auf: 2 unterscheidet sich von 1 durch kurzkettige, gespannte Alkylketten, mit denen Donor und Akzeptor verknüpft sind und teilweise in Konjugation gezwungen werden. Dies äußert sich in einer unvorteilhaften Delokalisierung der Grenzorbitale über Donor und Pyridinrest und mündet in einer Erniedrigung der relevanten. adiabatischen Triplett-Energie.

Die Moleküle Molekül-DFT-3 und -4 sind nicht erfindungsgemäß, sondern entsprechen dem Stand der Technik. Der Unterschied zu den Molekülen Molekül-DFT-5 und -6 besteht in einer zusätzlichen Spacereinheit. Dadurch sind für -3 und -4 jeweils auch Anteile des HOMOs auf dem Spacer, hier einer Phenyl-Gruppe, lokalisiert. In der Folge ergeben sich relativ niedrige adiabatische Triplett-Energien von 2.00 und 2.07 eV. Wird statt dessen wie durch diese Erfindung gelehrt ein erfindungsgemäßer Donor direkt an einen erfindungsgemäßen Akzeptor wie Triazin angeknüpft, so steigt im Vergleich dazu die adiabatische Triplett-Energie signifikant auf Werte von 2.64 bzw. 2.58 eV an. Damit ergibt sich für diesen Fall durch die Verwendung der erfindungsgemäßen Verknüpfung eine wünschenswerte Erhöhung der Triplett-Energie um 24 % gegenüber dem bisherigen Stand der Technik.

### Figuren

Es zeigen:
- Figur 1: Schematischer Aufbau einer OLED (Die Vorrichtung umfasst mindestens eine Anode, eine Kathode und eine Emitterschicht.).
- Figur 2: Berechnete Grenzorbitale des Grundzustands von Beispiel 2.
- Figur 3: Cyclovoltammogramm von Beispiel 1. Es finden ausschließlich reversible Prozesse statt.
- Figur 4: Anregungs- und Emissionsspektrum eines Filmes von Beispiel 1 (pur gelöst in Toluol) (Anregung bei 250 nm).
- Figur 5: Anregungs- und Emissionsspektrum eines Filmes von Beispiel 3 (pur gelöst in Toluol) (Anregung bei 320 nm).
- Figur 6: Kristallstruktur von 2,6-Bis-N-phenothiazinyl-pyridin.
- Figur 7: DFT Ergebnisse für die Moleküle DFT-1 bis DFT-6.

## Patentansprüche

1. Organisches Molekül, aufweisend eine Struktur der Formel 1: 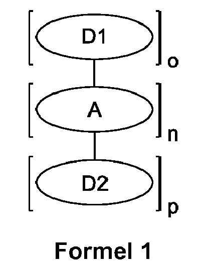 mit
A = eine Akzeptorgruppe mit elektronenziehenden Eigenschaften, unabhängig voneinander ausgewählt aus der Gruppe aus Pyridin, Pyridazin, Pyrimidin, Pyrazin, Triazin, Oxazol, Thiazol, Imidazol, Pyrazol, Isoxazol, Isothiazol, 1,2,3-Triazol, 1,2,4-Triazol, 1,2,4-Oxadiazol, 1,2,4-Thiadiazol, Tetrazol, 1,2,3,4-Oxatriazol, 1,2,3,4-Thiatriazol, die mit einem oder mehreren Resten R¹ substituiert sein können, wobei zwei oder mehr Reste R¹ miteinander verknüpft sein können und einen Ring bilden können, P(=O)R¹₂, P(=O)R¹, P(=S)R¹₂, P(=S)R¹, P(=Se)R¹₂, P(=Se)R¹, SO₂, Benzimidazol, Benzoxazol, Benzothiazol;
D1 = eine Gruppe, aufweisend eine Struktur der Formel 1a; 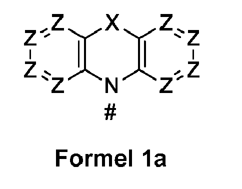 und
D2 = eine Gruppe, aufweisend eine Struktur der Formel 1b; 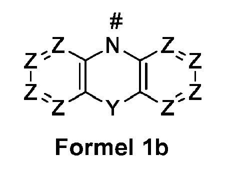 wobei mindestens zwei verschiedene Gruppen D1 und D2 verwendet werden und für die verwendeten Symbole und Indizes gilt:
n ist eine ganze Zahl zwischen 1 und 5;
o ist eine ganze Zahl zwischen 1 und 4;
p eine ganze Zahl zwischen 1 und 4;
wobei o + p ≤ 5;
X ist gleich oder verschieden eine bivalente Brücke ausgewählt aus O, S, S=O, SO₂, Se, Se=O, SeO₂, C(R³)₂, C=NR³, C=C(R³)₂, Si(R³)₂, N(R³), P(R³), P(=O)R³ oder B(R³);
Y ist bei jedem Auftreten gleich oder verschieden eine kovalente Einfachbindung oder eine bivalente Brücke ausgewählt aus O, S, S=O, SO₂, Se, Se=O, SeO₂, C(R³)₂, C=NR³, C=C(R³)₂, Si(R³)₂, N(R³), P(R³), P(=O)R³ oder B(R³);
Z ist bei jedem Auftreten gleich oder verschieden CR² oder N;
R¹ ist bei jedem Auftreten gleich oder verschieden Wasserstoff, Halogen, Deuterium, Gruppen, die über Stickstoff (-NR₂²) oder Sauerstoff- (-OR²) gebunden sind, Alkyl-(linear, verzweigt oder zyklisch), Heteroalkyl-, Aryl-, Heteroaryl-, Alkenyl-, Alkinyl-Gruppen oder substituierte Alkyl- (linear, verzweigt oder zyklisch), Heteroalkyl-, Aryl-, Heteroaryl- und Alkenyl-Gruppen mit Substituenten wie Halogene oder Deuterium, Alkylgruppen (linear, verzweigt oder zyklisch);
R² ist bei jedem Auftreten gleich oder verschieden Wasserstoff, Deuterium, Alkyl- (linear, verzweigt oder zyklisch), Heteroalkyl-, Aryl-, Heteroaryl-, Alkenyl-, Alkinyl-Gruppen oder substituierte Alkyl- (linear, verzweigt oder zyklisch), Heteroalkyl-, Aryl-, Heteroaryl- und Alkenyl-Gruppen mit Substituenten wie Halogene oder Deuterium, Alkylgruppen (linear, verzweigt oder zyklisch);
R³ ist bei jedem Auftreten gleich oder verschieden H, D, OR⁵, SR⁵ oder C(R⁵)₃;
R⁵ ist bei jedem Auftreten gleich oder verschieden Wasserstoff, eine Alkylgruppe oder eine Arylgruppe;
und wobei die Verknüpfung mit A jeweils an der mit # gekennzeichneten Stelle in Form einer Einfachbindung stattfindet.

2. Organisches Molekül nach Anspruch 1, wobei A eine Struktur der Formel 2a aufweist und n gleich 1 ist: 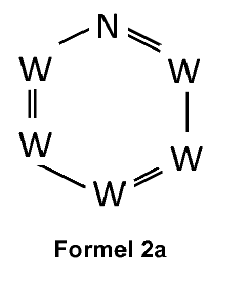 wobei W bei jedem Auftreten gleich oder verschieden CR¹ oder N ist.

3. Organisches Molekül nach Anspruch 1 oder 2, aufweisend eine Struktur der Formeln 3a bis 3m: 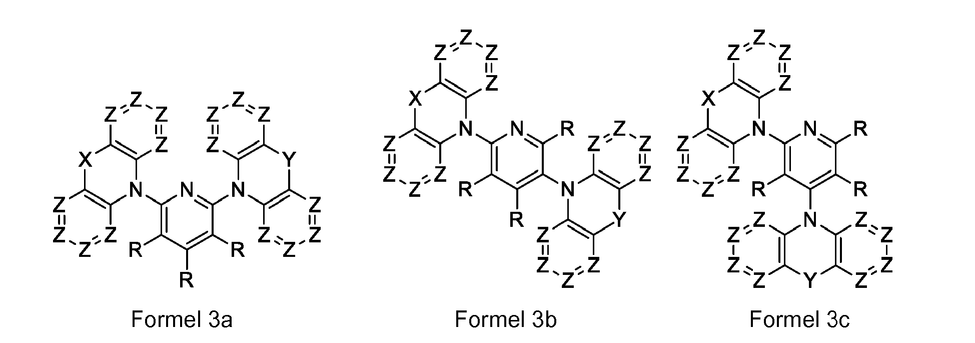 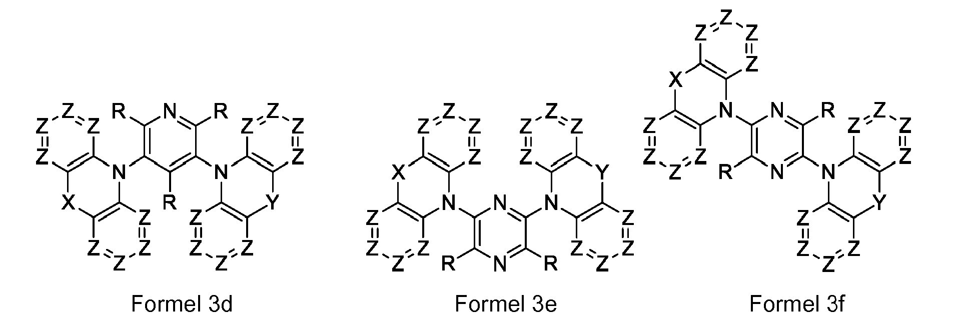 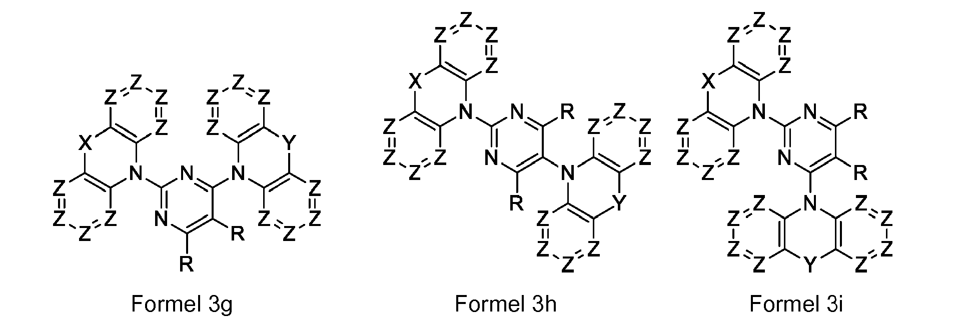 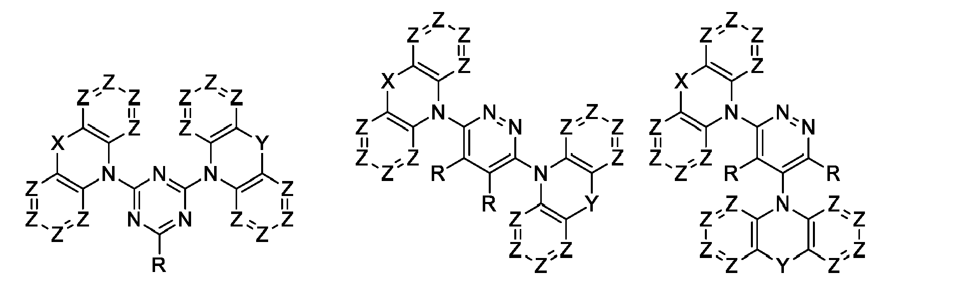 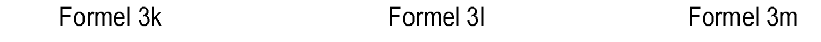 mit
X ist gleich oder verschieden eine bivalente Brücke ausgewählt aus O, S, S=O, SO₂, Se, Se=O, SeO₂, C(R³)₂, C=NR³, C=C(R³)₂, Si(R³)₂, N(R³), P(R³), P(=O)R³ oder B(R³);
Y ist bei jedem Auftreten gleich oder verschieden eine kovalente Einfachbindung oder eine bivalente Brücke ausgewählt aus O, S, S=O, SO₂, Se, Se=O, SeO₂, C(R³)₂, C=NR³, C=C(R³)₂, Si(R³)₂, N(R³), P(R³), P(=O)R³ oder B(R³); wobei X und Y verschieden zueinander sind;
Z ist bei jedem Auftreten gleich oder verschieden CR² oder N;
R ist bei jedem Auftreten gleich oder verschieden Wasserstoff, Halogen, Deuterium, Gruppen, die über Stickstoff (-NR₂²) oder Sauerstoff- (-OR²) gebunden sind, Alkyl-(linear, verzweigt oder zyklisch), Heteroalkyl-, Aryl-, Heteroaryl-, Alkenyl-, Alkinyl-Gruppen oder substituierte Alkyl- (linear, verzweigt oder zyklisch), Heteroalkyl-, Aryl-, Heteroaryl- und Alkenyl-Gruppen mit Substituenten wie Halogene oder Deuterium, Alkylgruppen (linear, verzweigt oder zyklisch);
R² ist bei jedem Auftreten gleich oder verschieden Wasserstoff, Deuterium, Alkyl- (linear, verzweigt oder zyklisch), Heteroalkyl-, Aryl-, Heteroaryl-, Alkenyl-, Alkinyl-Gruppen oder substituierte Alkyl- (linear, verzweigt oder zyklisch), Heteroalkyl-, Aryl-, Heteroaryl- und Alkenyl-Gruppen mit Substituenten wie Halogene oder Deuterium, Alkylgruppen (linear, verzweigt oder zyklisch);
R³ ist bei jedem Auftreten gleich oder verschieden H, D, OR⁵, SR⁵ oder C(R⁵)₃;
R⁵ ist bei jedem Auftreten gleich oder verschieden Wasserstoff, eine Alkylgruppe oder eine Arylgruppe.

4. Verfahren zur Herstellung eines Organischen Moleküls nach Anspruch 1 oder 2, aufweisend den folgenden Schritt:
Durchführen einer Reaktion von einem Difluor-substituierten Derivat von A mit D1 und D2,
wobei
A = unabhängig voneinander ausgewählt aus der Gruppe bestehend aus Pyridin, Pyridazin, Pyrimidin, Pyrazin, Triazin, Oxazol, Thiazol, Imidazol, Pyrazol, Isoxazol, Isothiazol, 1,2,3-Triazol, 1,2,4-Triazol, 1,2,4-Oxadiazol, 1,2,4-Thiadiazol, Tetrazol, 1,2,3,4-Oxatriazol, 1,2,3,4-Thiatriazol, die mit einem oder mehreren Resten R¹ substituiert sein können, wobei zwei oder mehr Reste R¹ miteinander verknüpft sein können und einen Ring bilden können, P(=O)R¹₂, P(=O)R¹, P(=S)R¹₂, P(=S)R¹, P(=Se)R¹₂, P(=Se)R¹, SO₂, Benzimidazol, Benzoxazol, Benzothiazol ;
D1 = eine Gruppe, aufweisend eine Struktur der Formel 1a; 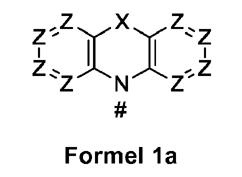
D2 = eine Gruppe, aufweisend eine Struktur der Formel 1b; 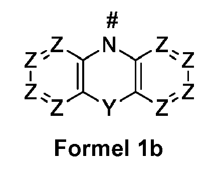
wobei mindestens zwei verschiedene Gruppen D1 und D2 verwendet werden und die Verknüpfung mit A jeweils an der mit # gekennzeichneten Stelle in Form einer Einfachbindung stattfindet;
und wobei die weiteren Symbole die in Anspruch 1 angegebenen Bedeutungen haben.

5. Verfahren nach Anspruch 4, wobei die Reaktion unter Zugabe einer starken Base durchgeführt wird.

6. Verfahren nach Anspruch 4 oder 5, weiterhin aufweisend den Schritt der Zugabe eines Oxidationsmittels unabhängig voneinander ausgewählt aus der Gruppe bestehend aus Wasserstoffperoxid, Wasserstoffperoxid-Harnstoff-Addukt, Sauerstoff oder Ozon und optional weiterhin aufweisend den weiteren Schritt der Zugabe von Selen oder Schwefel oder Lawessons Reagenz.

7. Mischung, enthaltend mindestens ein organisches Molekül nach Anspruch 1 bis 3 und mindestens einen lumineszierenden Emitter.

8. Formulierung, enthaltend mindestens ein organisches Molekül nach Anspruch 1 bis 3 oder eine Mischung nach Anspruch 7 und mindestens ein Lösemittel.
